# EUROPEAN PATENT APPLICATION

(11) **EP 4 672 292 A1**
(43) Date of publication of application: **31.12.2025**
(21) Application number: 23948950.3
(22) Date of filing: 13.09.2023
(51) Int. Cl.: H01H 45/04, H02B 1/24, H02B 1/26, H01M 10/04

(54) **POWER DISTRIBUTION APPARATUS, BATTERY, AND ELECTRIC DEVICE**

(30) Priority: 17.08.2023 CN 202311041171
(71) Applicant: Contemporary Amperex Technology Co., Limited, Ningde, Fujian 352100 (CN)
(72) Inventor: LI, Yuanxin, Ningde, Fujian 352100 (CN); WANG, Chong, Ningde, Fujian 352100 (CN); ZHENG, Chenling, Ningde, Fujian 352100 (CN); LI, Deshuo, Ningde, Fujian 352100 (CN)
(74) Representative: Ziebig Hengelhaupt Intellectual Property Attorneys Patentanwaltskanzlei PartGmbB
(86) International application number: PCT/CN2023/118561
(87) International publication number: WO 2025/035525

(57) **Abstract**

The present application relates to the field of batteries, and provides a power distribution apparatus (30), a battery (1), and an electrical device. The power distribution apparatus (30) includes a base (32) and a relay (312). The base (32) forms an accommodating cavity (321). The relay (312) includes a switch unit (3124), and at least part of an outer wall of the switch unit (3124) is exposed in the accommodating cavity (321). An inner wall of the accommodating cavity (321) is connected to the relay (312) to fix the relay (312) to the accommodating cavity (321). The power distribution apparatus (30) can fix the relay (312) in the accommodating cavity (321). Furthermore, the relay (312) fixed in the accommodating cavity (321) can use the inner wall of the accommodating cavity (321) to replace its own shell structure. Therefore, the own shell structure of the relay (312) can be omitted, an integrated and miniaturized power distribution apparatus can be formed, and design margin and space waste can be reduced.

## Description

### CROSS-REFERENCE TO RELATED APPLICATIONS

The present application claims priority to Chinese Patent Application No. 202311041171.4, filed with the China National Intellectual Property Administration on August 17, 2023, entitled "POWER DISTRIBUTION APPARATUS, BATTERY, AND ELECTRICAL DEVICE", which is incorporated herein by reference in its entirety.

### TECHNICAL FIELD

Embodiments of the present application relate to the field of batteries, and in particular, to a power distribution apparatus, a battery, and an electrical device.

### BACKGROUND

A power distribution apparatus is a control unit for distributing energy of a battery, and is particularly configured to perform high-voltage distribution for the battery. The power distribution apparatus generally includes a case and an electrical component such as a relay assembled in the case. However, the existing power distribution apparatus has a large design margin and space waste, resulting in a large size of the power distribution apparatus.

### SUMMARY OF THE INVENTION

Embodiments of the present application provide a power distribution apparatus, a battery, and an electrical device, aiming to solve the problem that the existing power distribution apparatus has a large design margin and space waste, resulting in a large size of the power distribution apparatus.

To achieve the aforementioned objective, technical solutions adopted in the embodiments of the present application are as follows:
In a first aspect, a power distribution apparatus is provided, including:
a base, forming an accommodating cavity; and
a relay fixedly mounted on the base, where the relay includes a switch unit, at least part of an outer wall of the switch unit is exposed in the accommodating cavity, and an inner wall of the accommodating cavity is connected to the relay to fix the relay in the accommodating cavity.

The power distribution apparatus provided in the embodiment of the present application can fix the relay in the accommodating cavity by accommodating the relay in the accommodating cavity of the base and connecting the inner wall of the accommodating cavity to the relay. On this basis, the relay fixedly mounted in the accommodating cavity can be protected by exposing at least part of the outer wall of its switch unit in the accommodating cavity so as to replace its own shell structure with the inner wall of the accommodating cavity. Based on this, while guaranteeing that the base is capable of achieving effects such as accommodating, position-limiting, fixing, and protecting for the relay, the own shell structure of the relay can be effectively omitted, which can facilitate compactness of the overall layout of the base and the relay, thereby facilitating formation of an integrated, miniaturized, lightweight, and simplified power distribution apparatus, effectively reducing the design margin, space waste, and occupied space of the power distribution apparatus, effectively reducing the weight of the power distribution apparatus, and helping reduce the production cost of the power distribution apparatus.

In some embodiments, the relay abuts against at least part of the inner wall.

By adopting the above solution, the relay can be made to abut against at least part of the inner wall to guarantee and enhance position-limiting and positioning effects of the inner wall of the accommodating cavity for the relay. Based on this, it may be conducive to stabilizing an mounting state of the relay in the accommodating cavity, especially stabilizing the state of the relay in the accommodating cavity reliably when the relay vibrates during operation, thereby reducing the risk of the relay being detached from the accommodating cavity. Furthermore, since the relay abuts against at least part of the inner wall, the space margin after the accommodating cavity fits the relay can be constrained and reduced, thereby helping reduce the design margin, space waste, and occupied space of the power distribution apparatus, and being conducive to miniaturization and lightweight of the power distribution apparatus.

In some embodiments, there is a first gap between the relay and at least part of the inner wall.

By adopting the above solution, during the assembling of the relay being picked and placed in the accommodating cavity, an assembling margin may be formed through the first gap between the relay and at least part of the inner wall, which provides an assembling space to facilitate smooth picking and placing of the relay in the accommodating cavity, thereby improving the assembling convenience and assembling efficiency between the relay and the accommodating cavity. When the relay has been placed in the accommodating cavity, a connection space may be further formed through the first gap between the relay and at least part of the inner wall, so that a mutual connection relationship can be established between the relay and the accommodating cavity at the connection space, thereby facilitating the relay to be stably and reliably fixed to the accommodating cavity.

In some embodiments, the first gap is configured to be filled with structural adhesive, and the relay is bonded to at least part of the inner wall by the structural adhesive.

By adopting the above solution, when the relay has been placed in the accommodating cavity, the connection space can be formed through the first gap between the relay and at least part of the inner wall, for being filled with the structural adhesive, so that the relay and the corresponding part of the inner wall can be reliably and firmly bonded together by the structural adhesive. Based on this, the fixing effect of the accommodating cavity for the relay can be effectively guaranteed and enhanced, which is conducive to stabilizing the mounting state of the relay in the accommodating cavity, especially stabilizing the state of the relay in the accommodating cavity reliably when the relay vibrates during operation. Furthermore, since the first gap can be used to be filled with the structural adhesive, the first gap may not constitute a space margin after the accommodating cavity fits the relay, thereby reducing the design margin, space waste, and occupied space of the power distribution apparatus, which may be conducive to the miniaturization and lightweight of the power distribution apparatus.

In some embodiments, the inner wall is provided with a protrusion structure, and the inner wall abuts against the relay through at least part of the protrusion structure.

By adopting the above solution, the inner wall of the accommodating cavity can be provided with the protrusion structure, so that at least part of the protrusion structure abuts against the relay, thereby guaranteeing and enhancing the position-limiting and positioning effects for the relay. Based on this, it is conducive to stabilizing the mounting state of the relay in the accommodating cavity, especially stabilizing the state of the relay in the accommodating cavity reliably when the relay vibrates during operation, thereby reducing the risk of the relay being detached from the accommodating cavity, and guaranteeing and improving the mounting stability and operation reliability of the relay. On this basis, a contact area between the inner wall of the accommodating cavity and the relay can be reduced accordingly. Based on this, a friction between the relay and the inner wall can be effectively reduced during the assembling of the relay being picked and placed in the accommodating cavity, thereby improving the assembling convenience between the relay and the accommodating cavity.

By adopting the above solution, it is further conducive for the inner wall to abut against the relay partially (that is, by at least part of the protrusion structure) to form the first gap with the relay partially (that is, with a region where the protrusion structure is not provided). Based on this, during the assembling of the relay being picked and placed in the accommodating cavity, the assembling margin can be formed by the first gap to provide an assembling space, thereby improving the assembling convenience between the relay and the accommodating cavity. When the relay has been placed in the accommodating cavity, the connection space can further be formed through the first gap, so as to stably and reliably fix the relay to the accommodating cavity.

In some embodiments, the accommodating cavity has an opening, and the inner wall includes a bottom wall, a top wall, a first side wall, a second side wall, and a third side wall. The bottom wall is configured to support the relay, the top wall is arranged opposite to the bottom wall, the first side wall is arranged opposite to the second side wall, and the third side wall is arranged opposite to the opening.

By adopting the above solution, it is convenient to pick and place the relay in the accommodating cavity through the opening. It is also convenient to achieve position-limiting and wrapping protection for the relay in a plurality of directions through the bottom wall, the top wall, the first side wall, the second side wall, and the third side wall when the relay has been placed in the accommodating cavity, thereby guaranteeing and improving the mounting stability of the relay in the accommodating cavity, and guaranteeing and improving effects such as accommodating, position-limiting, fixing, and protecting of the accommodating cavity for the relay.

In some embodiments, at least some walls among the bottom wall, the top wall, the first side wall, the second side wall, and the third side wall are provided with the protrusion structures.

By adopting the above solution, during the assembling of the relay being picked and placed in the accommodating cavity, at least some walls among the bottom wall, the top wall, the first side wall, the second side wall, and the third side wall can reduce a contact area between the wall and the relay through the provided protrusion structure, so as to reduce a friction between the wall and the relay. Moreover, the first gap can be formed between the relay and the region where the protrusion structure is not arranged, so as to form the assembling margin through the first gap to provide the assembling space. Therefore, the assembling convenience between the relay and the accommodating cavity can be improved.

By adopting the above solution, when the relay has been placed in the accommodating cavity, at least some walls among the bottom wall, the top wall, the first side wall, the second side wall, and the third side wall can abut against the relay through at least part of the protrusion structures, so as to guarantee and enhance the position-limiting and positioning effects for the relay. Moreover, the connection space can be formed through the first gap, so as to facilitate the relay to be stably and reliably fixed in the accommodating cavity. Therefore, the mounting stability of the relay in the accommodating cavity can be improved.

In some embodiments, the protrusion structures provided on the bottom wall, the top wall, the first side wall, and the second side wall are first protrusions, and the first protrusions are arranged to extend in a direction away from the opening.

By adopting the above solution, during the assembling of the relay being picked and placed in the accommodating cavity, at least some walls among the bottom wall, the top wall, the first side wall, and the second side wall can follow a disassembling and assembling direction of the relay and the accommodating cavity through the first protrusions extending in the direction away from the opening, so as to reduce the friction between the wall and the relay, especially reduce the friction in directions other than the disassembling and assembling direction. Therefore, the assembling convenience and assembling efficiency between the relay and the accommodating cavity can be improved while guaranteeing the position-limiting effect for the relay.

In some embodiments, the protrusion structure provided on the third side wall is a second protrusion. There are at least two second protrusions, and the second protrusions are cross-connected.

By adopting the above solution, when the relay has been placed in the accommodating cavity, the third side wall can abut against the relay through at least part of the cross-connected second protrusions to enhance the position-limiting and positioning effects for the relay. The first gap can be formed through cells between the second protrusions, so as to form the connection space by the first gap. Therefore, it can facilitate improving the mounting stability of the relay in the accommodating cavity.

In some embodiments, the accommodating cavity has an opening, the power distribution apparatus includes a covering member, and the covering member is connected to the base, for blocking the opening.

By adopting the above solution, when the relay has been placed in the accommodating cavity and the relay has been connected to the inner wall of the accommodating cavity, the opening of the accommodating cavity can be blocked by the covering member connected to the base. Based on this, on the one hand, the covering member can cooperate with the base to form all-round protection for the relay in the accommodating cavity, thereby guaranteeing and improving the protection effect of the power distribution apparatus on the relay, and guaranteeing and extending the service life of the relay and the power distribution apparatus. On the one hand, the covering member can reliably prevent the relay from being detached from the opening of the accommodating cavity, and in particular prevent the relay from being detached from the accommodating cavity due to vibration generated during operation, thereby guaranteeing and improving the mounting stability and mounting reliability of the relay by the power distribution apparatus. On the one hand, the covering member can reliably prevent external devices from contacting, colliding with, and damaging the relay, thereby guaranteeing and extending the service life of the relay and the power distribution apparatus, and to a certain extent also reducing the safety hazards of the power distribution apparatus.

In some embodiments, the covering member has a through hole penetrated for a contact of the relay to pass through.

By adopting the above solution, when the relay is arranged with its contact facing toward the side of the opening and the covering member blocks the opening of the accommodating cavity, the covering member may be provided with a through hole for the contact of the relay to pass through via the through hole, so that the contact of the relay is exposed from the covering member and connected to a high-voltage circuit to control on/off of the high-voltage circuit. Based on this, respective functions of the covering member and the relay can be taken into consideration, thereby guaranteeing the use performance of the power distribution apparatus.

In some embodiments, each covering member is provided with at least one through hole, each relay has at least two contacts, each through hole corresponds to at least one contact, and each through hole is used to allow the corresponding contact to pass through.

By adopting the above solution, when the relay is arranged with its contact facing toward the side of the opening and the covering member blocks the opening of the accommodating cavity, the covering member may be provided with at least one through hole, and at least two contacts of the relay are exposed in a one-to-one or one-to-many manner through the through hole. Based on this, the respective functions of the covering member and the relay can be taken into consideration, which can facilitate the various contacts of the relay to be connected to the high-voltage circuit and work together to control on/off of the high-voltage circuit. In particular, when each through hole corresponds to one contact, the contacts of the relay can be separated in different through holes, so as to improve the insulation performance between the contacts of the relay accordingly, thereby reducing the risk of short circuit and reducing the safety hazards of the power distribution apparatus.

In some embodiments, the covering member is provided with a barrier structure for separating two adjacent contacts of the relay.

By adopting the above solution, when each contact of the relay passes through the corresponding through hole of the covering member, the covering member can insulate and separate two adjacent contacts through the barrier structure provided between the two adjacent contacts. In this way, a creepage distance between two adjacent contacts can be effectively increased, and the insulation performance between two adjacent contacts can be effectively improved, thereby reducing the risk of short circuit and reducing the safety hazards of the power distribution apparatus.

In some embodiments, the power distribution apparatus includes a shielding member, and the shielding member is arranged on one side of the covering member away from the accommodating cavity and is configured to shield the contact of the relay.

By adopting the above solution, on the basis of taking into account the respective functions of the covering member and the relay, the covering member and the contact of the relay exposed from the through hole of the covering member can be shielded by the shielding member arranged on the side of the covering member away from the accommodating cavity, which particularly guarantees that the contact of the relay is not exposed to the outside of the power distribution apparatus. Based on this, on the one hand, the shielding member can be used to protect the covering member and the contact of the corresponding relay to guarantee and extend the service life of the relay and the power distribution apparatus. On the other hand, the shielding member can reliably prevent human hands or external devices from contacting with the contact of the relay to conduct electricity, thereby reducing the safety hazards of the power distribution apparatus and improving the use performance of the power distribution apparatus.

In some embodiments, the covering member is connected to the inner wall of the accommodating cavity by a snap.

By adopting the above solution, when the relay has been placed in the accommodating cavity and the relay has been connected to the inner wall of the accommodating cavity, the covering member can be aligned and fit to the side of the relay close to the opening, and the snap of the covering member is correspondingly snap-connected to the inner wall of the accommodating cavity, so as to conveniently and quickly realize the detachable connection of the covering member to the base. Based on this, the connection convenience and connection reliability between the covering member and the base can be guaranteed and improved, and it can be guaranteed that the covering member is capable of accurately and reliably blocking the opening of the accommodating cavity.

In some embodiments, there are at least two accommodating cavities, there are at least two relays, and at least some of the relays are mounted in the accommodating cavities in a one-to-one manner.

By adopting the above solution, the base can fix and mount at least two relays in a one-to-one manner through the at least two accommodating cavities. Based on this, it can be guaranteed that the base is capable of, through each accommodating cavity, playing the functions such as accommodating, position-limiting, fixing, and protecting for each relay fixedly mounted in the accommodating cavity. At the same time, own shell structures of the at least two relays can be omitted, thereby making the overall layout of the base and the relays compact to a great extent, which is more conducive to the integration, miniaturization, lightweight, and simplification of the power distribution apparatus.

In some embodiments, the base is provided with at least one insulating structure, and the insulating structure is arranged between two adjacent accommodating cavities, for separating contacts of two corresponding relays.

By adopting the above solution, the base may be provided with the insulating structure between two adjacent accommodating cavities, so as to insulate and separate the two adjacent accommodating cavities by the insulating structure. Therefore, two relays correspondingly mounted in the two accommodating cavities can be insulated and separated by the insulating structure, and in particular, contacts of the two corresponding relays can be insulated and separated. In this way, the insulation performance between the contacts of two adjacent shellless relays can be effectively improved, the risk of short circuit can be reduced, and the reliability and safety of using the power distribution apparatus can be improved.

In some embodiments, the power distribution apparatus includes an electrical component and a cover body, the electrical component includes the relay, and at least two electrical components are provided and are both mounted on the base.

The cover body is arranged on the same side of each electrical component and connected to the base. A circuit element is arranged on one side of the cover body facing each electrical component, for being electrically connected to each electrical component.

By adopting the above solution, by mounting the electrical components on the base, on the one hand, it can facilitate the planning, optimization, and compactness of the layout of the electrical components, thereby facilitating compactness of the overall layout of the base and the electrical components, and facilitating the integration, miniaturization, lightweight, and simplification of the power distribution apparatus. On the other hand, the base, in combination with the cover body connected to the base, can together form reliable protection for the electrical components mounted on the base, thereby guaranteeing and extending the service life of the electrical components and the power distribution apparatus.

By adopting the above solution, by integrating the circuit element on the side of the cover body facing the electrical components, the cover body can provide better protection for the circuit element, so as to reduce the risk of damage to the circuit element, thereby guaranteeing and extending the service life of the circuit element. Furthermore, when the cover body is assembled to the base, accurate alignment and electrical connection fitting between the circuit element and the electrical components can be accomplished simultaneously, thereby reliably constructing electrical connection relationships required by the electrical components through the circuit element, and guaranteeing that the power distribution apparatus is capable of achieving the required functions. Moreover, the number of assembling steps can further be reduced, thereby improving the connection convenience and connection reliability between the circuit elements and the electrical components, and improving the assembling convenience and assembling efficiency of the power distribution apparatus.

In some embodiments, a gap between an electrical component and an adjacent electrical component is a second gap. The electrical component is provided with a first connecting element, the first connecting element includes a first connecting portion for being detachably connected to the circuit element, and the first connecting portion is located outside the second gaps of the corresponding electrical components.

By adopting the above solution, in the case that the gap between each electrical component and the adjacent electrical component is defined as the second gap, by arranging the first connecting portion outside the second gaps of the corresponding electrical components, on the one hand, it is convenient to perform a connection operation of the first connecting portion in the space outside the second gaps of the corresponding electrical components, thereby guaranteeing and improving the operational convenience of connecting and disconnecting the first connecting portion. On the other hand, the second gaps of the electrical components neither need to provide an accommodation space for the first connecting portion, nor need to provide a connection operation space for the first connecting portion, thereby facilitating compressing the gap between the electrical component and the adjacent electrical component as needed, which facilitates compactness of the overall layout of the electrical components, thereby facilitating the formation of an integrated, compact, and miniaturized power distribution apparatus.

In some embodiments, the circuit element includes a connector and a second connecting element, the connector is embedded in the cover body, and a socket of the connector is exposed outside the cover body.

The second connecting element includes a conductive connecting portion and a second connecting portion, one end of the conductive connecting portion is connected to the connector, the other end of the conductive connecting portion is connected to the second connecting portion, and the second connecting portion is arranged to bend toward the corresponding electrical component for being detachably connected to the corresponding electrical component.

In some embodiments, the conductive connecting portion is embedded in the cover body.

By adopting the above solution, the cover body can provide better protection for a part of the conductive connecting portion embedded in the cover body, thereby reducing the risk such as interference, wear, and damage to the conductive connecting portion, and extending the service life of the conductive connecting portion and the circuit element. Furthermore, since the conductive connecting portion is embedded in the cover body, the mounting stability and mounting accuracy of the circuit element relative to the cover body can be guaranteed and improved. Based on this, when the cover body is assembled to the base and the electrical connection fitting between the circuit element and the electrical components is completed at the same time, the alignment accuracy between the circuit element and the electrical components can be effectively improved, thereby improving the connection convenience and connection reliability between the circuit element and the electrical components.

In some embodiments, the cover body, the connector, and the conductive connecting portion form an integrated structure.

By adopting the above solution, the cover body as well as the connector and the conductive connecting portion embedded in the cover body can form the integrated structure. Based on this, the connection reliability, connection tightness, connection stability, and connection strength between the cover body and the connector and between the cover body and the conductive connecting portion can be effectively enhanced, the comprehensive structural strength of the cover body, the connector, and the conductive connecting portion can be effectively enhanced, the protective effect of the cover body on the connector and the conductive connecting portion can be effectively enhanced, the risk of wear and damage to the connector can be reduced, and the risk such as interference and wear of the conductive connecting portion can be reduced.

By adopting the above solution, the assembling process between the cover body and the connector, and between the cover body and the conductive connecting portion can be simplified. During assembling of the cover body, it is also convenient to complete precise alignment between the second connecting portion of the second connecting element and the first connecting portion of the corresponding electrical component, and complete electrical connection fitting between the second connecting portion and the corresponding first connecting portion. That is, the connecting process between the second connecting element and the electrical component can be simplified, thereby effectively reducing the assembling steps, effectively guaranteeing and improving the reliability of the connection of the connector to the electrical component, and effectively improving the assembling efficiency and structural reliability of the power distribution apparatus.

In some embodiments, the power distribution apparatus includes an electrical component and an insulating heat-conducting member, the electrical component includes the relay, and the electrical component is mounted on the base.

One side of the insulating heat-conducting member is connected to at least part of the electrical component, and the other side of the insulating heat-conducting member is used to be connected to a heat exchange member. The insulating heat-conducting member is configured to transfer heat from the electrical component to the heat exchange member.

By adopting the above solution, the power distribution apparatus can be insulated and heat-conductively connected to the electrical component through the insulating heat-conducting member, and can be insulated and heat-conductively connected to the external heat exchange member through the insulating heat-conducting member. Based on this, on the one hand, the insulation performance of the insulating heat-conducting member can be used to guarantee that the electrical component and the heat exchange member can be insulated through the insulating heat-conducting member, thereby basically avoiding short circuits between the electrical component, the insulating heat-conducting member, and the heat exchange member, and effectively reducing the risk of high-voltage short circuit ignition between the electrical component, the insulating heat-conducting member, and the heat exchange member. On the other hand, it is convenient to exchange heat and conduct heat between the electrical component and the heat exchange member through the insulating heat-conducting member, especially to conduct heat generated by the electrical component to the heat exchange member through the insulating heat-conducting member, so as to diffuse and dissipate the heat generated by the electrical component to the outside of the power distribution apparatus. As a result, the heat dissipation performance and heat dissipation efficiency of the power distribution apparatus for the electrical component can be effectively guaranteed and improved, the risk of thermal failure of the electrical component can be effectively reduced, and the service life of the electrical component and the power distribution apparatus can be effectively guaranteed and extended.

In some embodiments, the power distribution apparatus includes an encapsulating seat, and the encapsulating seat is connected to one side of the base close to the insulating heat-conducting member.

The insulating heat-conducting member is mounted on the encapsulating seat, and a surface of the insulating heat-conducting member away from the electrical component is exposed from the encapsulating seat.

By adopting the above solution, the insulating heat-conducting member can be mounted and fixed through the encapsulating seat, so that the mounting position and mounting state of the insulating heat-conducting member relative to the encapsulating seat are stable and firm, thereby facilitating the precise and stable alignment of the insulating heat-conducting member and the electrical component, and facilitating the accurate and reliable establishment of an insulating heat-connecting connection relationship between the insulating heat-conducting member and the electrical component. On this basis, the side of the insulating heat-conducting member facing the electrical component is insulated and heat-conductively connected to the electrical component, and the surface of the insulating heat-conducting member away from the electrical component is exposed from the encapsulating seat and heat-conductively connected to the heat exchange member; therefore, the insulating heat-conducting member can be directly insulated and heat-conductively connected between the electrical component and the heat exchange member, thereby reducing the blocking effect of the encapsulating seat on a heat-conducting path of the insulating heat-conducting member, and guaranteeing and improving the heat-conducting effect of the insulating heat-conducting member between the electrical component and the heat exchange member.

In a second aspect, a battery is provided, including the power distribution apparatus according to the embodiment of the present application.

By adopting the above solution, the battery can guarantee and improve the space utilization, volume utilization, and energy density of the battery by applying the power distribution apparatus according to the embodiment of the present application.

In a third aspect, an electrical device is provided, including the battery according to the embodiment of the present application.

By adopting the above solution, the electrical device can guarantee and improve the use performance of the electrical device by applying the battery according to the embodiment of the present application.

### BRIEF DESCRIPTION OF DRAWINGS

In order to clearly illustrate the technical solutions in embodiments of the present application, the accompanying drawings that need to be used in the description of the embodiments or the prior art will be briefly introduced below, and it will be obvious that the accompanying drawings in the following description are only some of the embodiments of the present application, and that other accompanying drawings can be obtained based on these drawings for a person of ordinary skill in the art, without any creative labor.
FIG. 1 is a schematic structural diagram of a vehicle according to some embodiments of the present application;
FIG. 2 is an exploded schematic diagram of a battery according to some embodiments of the present application;
FIG. 3 is a schematic diagram of a partial structure of a battery according to some embodiments of the present application;
FIG. 4 is a schematic structural diagram of a power distribution apparatus according to some embodiments of the present application;
FIG. 5 is a schematic structural diagram of an assembly of a base, a relay, and a covering member according to some embodiments of the present application;
FIG. 6 is an exploded schematic diagram of the base, the relay, and the covering member provided in FIG. 5;
FIG. 7 is a schematic structural diagram of an assembly of a base and a relay according to some embodiments of the present application;
FIG. 8 is a schematic structural diagram of a base according to some embodiments of the present application;
FIG. 9 is a first exploded schematic diagram of a power distribution apparatus according to some embodiments of the present application;
FIG. 10 is an exploded schematic diagram of various electrical components, a cover body, and a circuit element provided in FIG. 9;
FIG. 11 is a second exploded schematic diagram of the power distribution apparatus provided in FIG. 9;
FIG. 12 is a front view of a power distribution apparatus according to some embodiments of the present application; and
FIG. 13 is a sectional diagram along A-A provided in FIG. 12.

Here, the reference numerals in the figures are:
1-Battery, 2-Controller, 3-Motor; 10-Battery unit; 20-Box, 21-First part, 22-Second part; 30-Power distribution apparatus; 40-Heat exchange member, 41-Heat management component;
31-Electrical component, 311-Conductive structure, 3111-Heat-conducting surface, 3112-First conductive portion, 3113-Second conductive portion, 3114-Third conductive portion; 312-Relay, 3121-Main positive relay, 3122-Main negative relay, 3123-Pre-charging relay, 3124-Switch unit, 31241-Iron core, 31242-Coil, 31243-Bracket; 3125-Contact; 313-Current sensor, 3131-Shunt, 3132-Hall current sensor; 314-Fuse, 3141-Main fuse, 315-Pre-charging resistor; 316-Second gap, 317-First connecting element, 3171-First connecting portion; 32-Base, 321-Accommodating cavity, 3211-Inner wall, 3212-Bottom wall, 3213-Top wall, 3214-First side wall, 3215-Second side wall, 3216-Third side wall, 3217-Opening; 322-First gap; 323-Protrusion structure, 3231-First protrusion, 3232-Second protrusion; 324-Insulating structure; 33-Covering member, 331-Through hole, 332-Barrier structure, 333-Snap; 34-Shielding member; 35-Cover body; 36-Circuit element, 361-Connector, 3611-Socket, 362-Second connecting element, 3621-Second connecting portion, 3622-Conductive connecting portion; 37-Insulating heat-conducting member; 38-Encapsulating seat, 381-First position-limiting structure, 382-Second position-limiting structure.

### DETAILED DESCRIPTION

In order to make the technical problems, technical solutions, and beneficial effects to be solved by the present application clear, the following is a detailed explanation of the present application in conjunction with the accompanying drawings and embodiments. It should be understood that the specific embodiments described herein are merely used to explain the present application but are not intended to limit the present application.

In the descriptions of the present application, it should be understood that orientations or positional relationships indicated by "length", "width", "upper", "lower", "front", "rear", "left", "right", "vertical", "horizontal", "top", "bottom", "inner", "outer", and the like are orientations or positional relationships as shown in the drawings, and are only for the purpose of facilitating and simplifying the descriptions of the present application instead of indicating or implying that devices or elements indicated must have particular orientations, and be constructed and operated in the particular orientations, so that these terms are not construed as limiting The present application.

Moreover, terms "first" and "second" are merely used for the purpose of description, and cannot be understood as indicating or implying relative importance or implicitly indicating the number of indicated technical features. Therefore, features limited by "first" and "second" may explicitly or implicitly include one or at least two features. In the description of the present application, "at least two" means two or more than two, unless otherwise specified.

In the present application, unless otherwise expressly specified and limited, terms such as "mount", "connected", "connect", and "fix" should be broadly understood, for example, they may be a fixed connection or a detachable connection or be integrated; or may be a mechanical connection or an electrical connection; or may be a direct connection or an indirect connection through an intermediate medium, or may be a communication between the interior of two elements or an interaction of two elements. For those of ordinary skill in the art, the specific meanings of the above terms in the present application can be understood according to specific situations.

In a battery, a power distribution apparatus is a control unit for distributing energy of the battery, and in particular, configured to perform high-voltage distribution for the battery. In some cases, the power distribution apparatus includes a case and an electrical component such as a relay assembled in the case. However, for assembling and fitting of the components of the power distribution apparatus, there is a large design margin and space waste in the power distribution apparatus, which leads to a large size of the power distribution apparatus and is not conducive to the miniaturization of the power distribution apparatus.

Therefore, a power distribution apparatus is provided in some embodiments of the present application. The power distribution apparatus can fix the relay in an accommodating cavity by accommodating the relay in the accommodating cavity of a base and connecting an inner wall of the accommodating cavity to the relay. On this basis, the relay fixedly mounted in the accommodating cavity can be protected by exposing at least part of an outer wall of its switch unit in the accommodating cavity so as to replace its own shell structure with the inner wall of the accommodating cavity. Based on this, while guaranteeing that the base is capable of achieving effects such as accommodating, position-limiting, fixing, and protecting for the relay, the own shell structure of the relay can be effectively omitted, which can facilitate compactness of the overall layout of the base and the relay, thereby facilitating formation of an integrated, miniaturized, lightweight, and simplified power distribution apparatus, effectively reducing the design margin, space waste, and occupied space of the power distribution apparatus, effectively reducing the weight of the power distribution apparatus, and helping reduce the production cost of the power distribution apparatus.

The power distribution apparatus disclosed in the embodiments of the present application may be applied in a battery, to serve as a control unit for distributing energy of the battery and performing high-voltage distribution for the battery.

The battery disclosed in the embodiments of the present application may be a modular structure including at least one battery cell to provide higher voltage and capacity, such as a battery module or a battery pack. The battery cell may be a lithium-ion secondary battery, a lithium-ion primary battery, a lithium-sulfur battery, a sodium-lithium-ion battery, a sodium-ion battery, a magnesium-ion battery, or the like. The battery cell may be cylindrical, flat, cuboid, or other shapes. The battery cell may adopt different encapsulation methods to form a cylindrical battery cell, a prismatic battery cell, a pouch battery cell, or the like.

The battery disclosed in the embodiments of the present application can be used in an electrical device that uses a battery as a power source or in various energy storage systems that use batteries as energy storage elements. The electrical device can be, but is not limited to, a vehicle, a mobile phone, a portable device, a laptop computer, a ship, a spacecraft, an electric toy, a power tool, and the like. The vehicle may be a fuel vehicle, a gas vehicle, or a new energy vehicle, and the new energy vehicle may be a battery electric vehicle, a hybrid electric vehicle, an extended range vehicle, and the like. The spacecraft includes an airplane, a rocket, a space shuttle, a spaceship, and the like. The electric toy may include fixed or mobile electric toys, such as a game machine, an electric vehicle toy, an electric ship toy, an electric airplane toy, and the like. The electric tool includes an electric metal cutting tool, an electric grinding tool, an electric assembling tool, an electric tool for railways, such as, an electric drill, an electric grinding machine, an electric wrench, an electric screwdriver, an electric hammer, an electric impact drill, a concrete vibrator, and an electric planer.

To illustrate the technical solutions according to the present application, the following detailed description is provided in conjunction with specific drawings and embodiments, and taking "the electrical device being a vehicle" as an example.

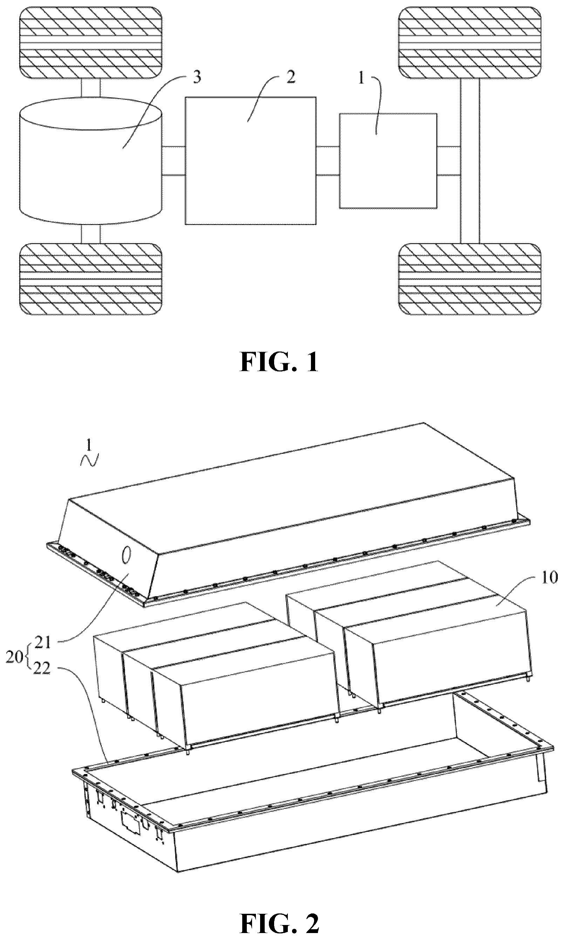

Referring to FIG. 1, FIG. 1 is a schematic structural diagram of a vehicle according to some embodiments of the present application. The vehicle may be a fuel vehicle, a gas vehicle, or a new energy vehicle, and the new energy vehicle may be a battery electric vehicle, a hybrid electric vehicle, an extended range vehicle, and the like. The interior of the vehicle is provided with a battery 1, and the battery 1 may be provided at the bottom or head or tail of the vehicle. The battery 1 is configured to supply power to the vehicle. For example, the battery 1 can serve as an operational power source for the vehicle. The vehicle may further include a controller 2 and a motor 3. The controller 2 is used to control the battery 1 to power the motor 3, for example, for meeting operating power demands when the vehicle is starting, navigating, and traveling.

In some embodiments of the present application, the battery 1 can not only serve as an operating power source of the vehicle, but also serve as a driving power source of the vehicle, thus replacing or partially replacing fuel or natural gas to provide driving power for the vehicle.

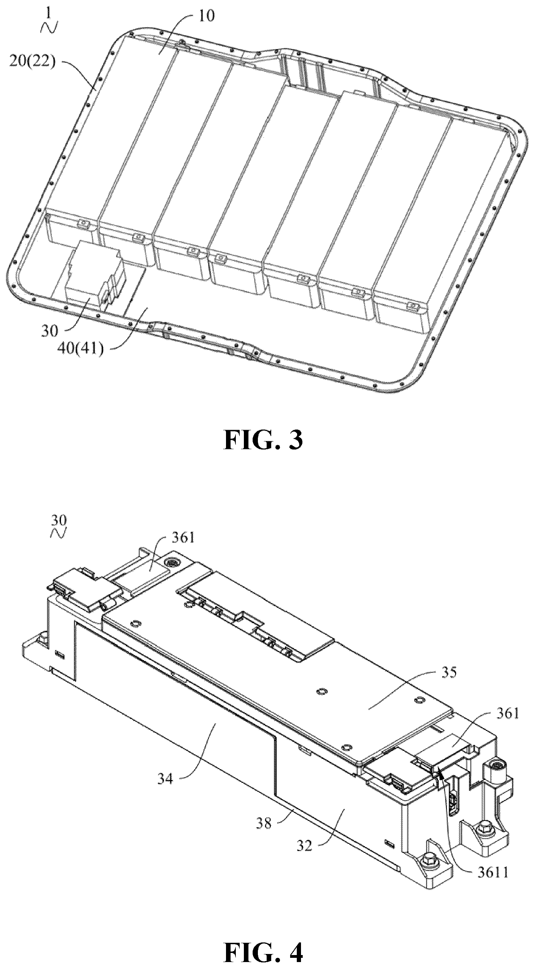

Referring to FIG. 2 and FIG. 3, FIG. 2 is an exploded schematic diagram of a battery 1 according to some embodiments of the present application, and FIG. 3 is a schematic diagram of a partial structure the battery 1 according to some embodiments of the present application. The battery 1 includes a battery unit 10 and a box body 20, and the battery unit 10 is accommodated within the box body 20. The box body 20 is configured to provide a accommodating space for the battery unit 10, and the structure of the box body 20 may be designed in a diversified and flexible manner. In some embodiments, the box body 20 may include a first part 21 and a second part 22, the first part 21 and the second part 22 covering each other, and the first part 21 and the second part 22 collectively defining the accommodating space for accommodating the battery unit 10. The second part 22 may be of a hollow structure with an opening at one end, and the first part 21 may be of a plate-like structure, where the first part 21 covers the opening side of the second part 22 so that the first part 21 and the second part 22 collectively define the accommodating space. The first part 21 and the second part 22 may each be of a hollow structure with an opening at one end, where the opening side of the first part 21 covers the opening side of the second part 22. Of course, the box body 20 formed by the first part 21 and the second part 22 may be of various shapes, such as a cylinder or a cuboid.

In the battery 1, there may be at least two battery units 10, and the at least two battery units 10 may be connected in series, in parallel, or in parallel-series, and the parallel-series connection means that the at least two battery units 10 are connected in both series and parallel.

Specifically, the battery unit 10 may be a battery cell. The at least two battery cells may be directly connected in series, in parallel, or in parallel-series, and then the entirety composed of the at least two battery cells is accommodated in the box body 20. The battery cell may be a lithium-ion secondary battery, a lithium-sulfur battery, a sodium-lithium-ion battery, a sodium-ion battery, a magnesium-ion battery, or the like. The battery cell may be cylindrical, flat, cuboid, or other shapes. The battery cell may adopt different encapsulation methods to form a cylindrical battery cell, a prismatic battery cell, a pouch battery cell, or the like.

Alternatively, the battery unit 10 may be a battery module or a battery pack. The at least two battery cells may first be connected in series, in parallel, or in parallel-series to form a modular structure, that is, a battery module or battery pack. Then, at least two battery modules or battery packs may be connected in series, in parallel, or in parallel-series to form an entirety, which is accommodated within the box body 20.

In some embodiments, the battery 1 may further include a power distribution apparatus 30, and the power distribution apparatus 30 is accommodated in the accommodation space of the box body 20. The power distribution apparatus 30 is connected to the battery unit 10 and the like. The power distribution apparatus 30 may serve as a control unit for distributing the energy of the battery 1 and perform high-voltage distribution for the battery 1.

In some embodiments, the battery 1 may further include a heat management component 41. The heat management component 41 is accommodated within the accommodating space of the box body 20 and configured to exchange heat with components such as the battery unit 10 and the power distribution apparatus 30 to regulate the temperature of the battery 1. The heat management component 41 may be a liquid cooling plate. In some embodiments, a single heat management component 41 may be provided and arranged on the same side as components such as the battery unit 10 and the power distribution apparatus 30 to facilitate heat exchange with the components such as the battery unit 10 and the power distribution apparatus 30. Certainly, in some embodiments, at least two heat management components 41 may be provided to facilitate flexible design of the positions and states of the heat management components 41, thereby enabling the at least two heat management components 41 to separately exchange heat with components such as the battery unit 10 and the power distribution apparatus 30. The heat management component 41 may further be an air cooling system. An airflow generated by the air cooling system can pass through components such as the battery unit 10 and the power distribution apparatus 30 to facilitate heat exchange with the components such as the battery unit 10 and the power distribution apparatus 30. Certainly, the heat management component 41 may also adopt other structural forms.

Certainly, the battery 1 may also include other structures. For example, the battery 1 may also include a busbar component (not shown in the figures) configured to achieve an electrical connection between the at least two battery units 10.

Certainly, in some embodiments, the battery 1 may not include the box body 20, but at least two battery units 10 may be electrically connected and formed into an entirety through a necessary fixing structure, and the entirety is then assembled into an electrical device.

Referring to FIG. 4, FIG. 5, and FIG. 6, a power distribution apparatus 30 is provided in some embodiments of the present application. The power distribution apparatus 30 includes a base 32 and a relay 312. The base 32 forming an accommodating cavity 321. The relay 312 is fixedly mounted on the base 32. The relay 312 includes a switch unit 3124, and at least part of an outer wall of the switch unit 3124 is exposed in the accommodating cavity 321. An inner wall 3211 of the accommodating cavity 321 is connected to the relay 312 to fix the relay 312 to the accommodating cavity 321.

It should be noted that the base 32 is a case component of the power distribution apparatus 30 and has a certain structural strength and rigidity. The base 32 is provided with at least one accommodating cavity 321, and the accommodating cavity 321 can be used for fixing and mounting the relay 312. The accommodating cavity 321 has an opening 3217, and the opening 3217 of the accommodating cavity 321 allows the relay 312 to be picked and placed in the accommodating cavity 321. The opening 3217 of the accommodating cavity 321 may be arranged on any side of the base 32. When there are at least two accommodating cavities 321, the openings 3217 of the at least two accommodating cavities 321 may be arranged on the same side of the base 32, or may be arranged on different sides of the base 32.

It should be further noted that, the relay 312 is an electrical control device, which is an electrical component 31 that, when a change in an input quantity (excitation quantity) reaches a specified requirement, causes a predetermined step change in a controlled quantity in an electrical output circuit. The relay 312 may include a main positive relay 3121, a main negative relay 3122, or the like.

The relay 312 includes a contact 3125 and the switch unit 3124. The contact 3125 is configured to be connected to a high-voltage circuit, and the switch unit 3124 is configured to control the contact 3125 to be closed or opened. By closing or opening the contact 3125, on/off of the high-voltage circuit can be controlled. In some embodiments, the switch unit 3124 may generate electromagnetism when a current passes through, causing the contact 3125 to be closed or opened. For example, the switch unit 3124 may include an iron core 31241 and a coil 31242 wound around the outside of the iron core 31241. The coil 31242 can generate electromagnetism when the current passes through, causing the contact 3125 to be closed or opened. Of course, in other embodiments, the switch unit 3124 may adopt other structural forms, or may adopt other principles to achieve controlling the closing or opening of the contact 3125.

It should also be further noted that the relay 312 can be fixedly mounted in the accommodating cavity 321. The number of the arranged relays 312 may be greater than or equal to the number of the arranged accommodating cavities 321, so that at least some of the relays 312 may be fixedly mounted in each accommodating cavity 321 in a one-to-one manner.

The relay 312 fixedly mounted in the accommodating cavity 321 may allow at least part of the outer wall of the switch unit 3124 to be exposed in the accommodating cavity 321. The outer wall of the switch unit 3124 includes exposed outer surface portions of the components of the switch unit 3124. For example, the switch unit 3124 includes an iron core 31241 and a coil 31242 wound around the outside of the iron core 31241. If the outer peripheral surface of the iron core 31241 is completely wound around and blocked by the coil 31242, the outer wall of the switch unit 3124 mainly includes the outer peripheral surface of the outermost circle of the coil 31242. If the outer peripheral surface of the iron core 31241 is partially wound around and blocked by the coil 31242, the outer wall of the switch unit 3124 includes the outer peripheral surface of the outermost circle of the coil 31242 and the outer peripheral surface of the iron core 31241 that is not blocked by the coil 31242. For another example, the switch unit 3124 includes an iron core 31241, a coil 31242 wound around the outside of the iron core 31241, and a bracket 31243 for supporting and fixing the iron core 31241. Then, the outer wall of the switch unit 3124 may include an outer surface of the bracket 31243, an outer peripheral surface of the outermost circle of the coil 31242 not blocked by the bracket 31243, an the outer peripheral surface of the iron core 31241 not blocked by the bracket 31243 and the coil 31242.

Based on this, the relay 312 fixedly mounted in the accommodating cavity 321 is capable of using the inner wall 3211 of the accommodating cavity 321 to replace its own shell structure for protection. Therefore, the own shell structure of the relay 312 can be omitted, that is, the relay 312 fixedly mounted in the accommodating cavity 321 is a shellless relay. The inner wall 3211 of the accommodating cavity 321 refers to various walls that participate in enclosing and forming the accommodating cavity 321.

On this basis, the inner wall 3211 of the accommodating cavity 321 may be connected to the relay 312 located therein to fix the relay 312 to the accommodating cavity 321 and limit the relay 312 from being detached from the accommodating cavity 321, especially limiting the relay 312 from being detached from the accommodating cavity 321 due to vibration during operation. The inner wall 3211 of the accommodating cavity 321 may be connected to the relay 312 in a detachable connection manner or a fixed connection manner, so as to fix the relay 312 to the accommodating cavity 321. The detachable connection method may adopt but is not limited to snap connection, screw locking, and other methods. The fixed connection method may include but is not limited to bonding and the like.

In view of the above, the power distribution apparatus 30 provided in the embodiment of the present application can fix the relay 312 in the accommodating cavity 321 by accommodating the relay 312 in the accommodating cavity 321 of the base 32 and connecting the inner wall 3211 of the accommodating cavity 321 to the relay 312. On this basis, the relay 312 fixedly mounted in the accommodating cavity 321 can be protected by exposing at least part of an outer wall of its switch unit 3124 in the accommodating cavity 321 so as to replace its own shell structure with the inner wall 3211 of the accommodating cavity 321. Based on this, while guaranteeing that the base 32 is capable of achieving effects such as accommodating, position-limiting, fixing, and protecting for the relay 312, the own shell structure of the relay 312 can be effectively omitted, which can facilitate compactness of the overall layout of the base 32 and the relay 312, thereby facilitating formation of an integrated, miniaturized, lightweight, and simplified power distribution apparatus 30, effectively reducing the design margin, space waste, and occupied space of the power distribution apparatus 30, effectively reducing the weight of the power distribution apparatus 30, and helping reduce the production cost of the power distribution apparatus 30.

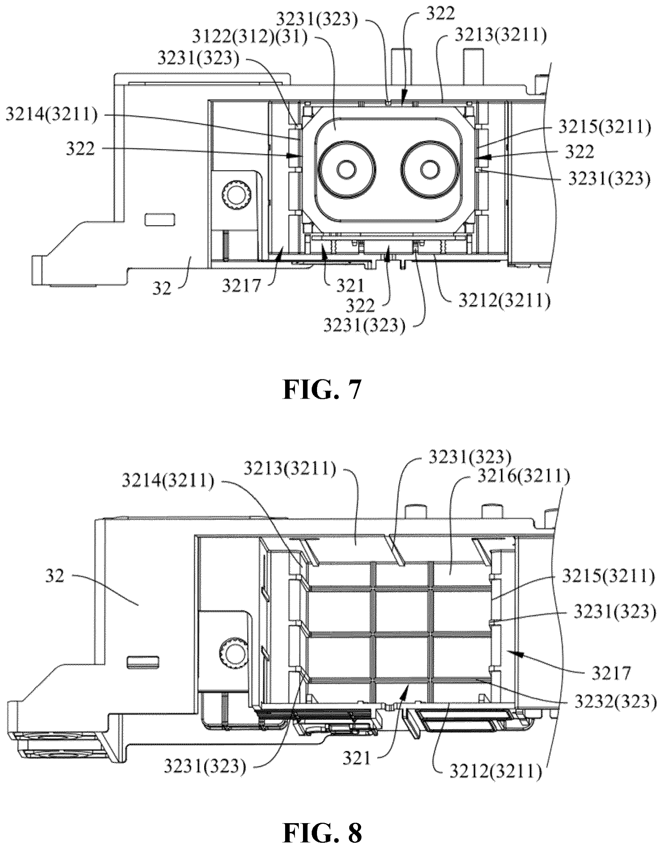

Referring to FIG. 4, FIG. 7, and FIG. 8, in some embodiments of the present application, the relay 312 abuts against at least part of the inner wall 3211.

It should be noted that, the inner wall 3211 of the accommodating cavity 321 includes various walls that participate in enclosing and forming the accommodating cavity 321. The relay 312 may abut against one wall or may abut against at least two walls. The wall that abuts against the relay 312 may abuts against the relay 312 partially or abuts against the relay 312 entirely (that is, the entire wall).

By adopting the above solution, the relay 312 can be made to abut against at least part of the inner wall 3211 to guarantee and enhance position-limiting and positioning effects of the inner wall 3211 of the accommodating cavity 321 on the relay 312. Based on this, it may be conducive to stabilizing an mounting state of the relay 312 in the accommodating cavity 321, especially stabilizing the state of the relay 312 in the accommodating cavity 321 reliably when the relay 312 vibrates during operation, thereby reducing the risk of the relay 312 being detached from the accommodating cavity 321. Furthermore, since the relay 312 abuts against at least part of the inner wall 3211, the space margin after the accommodating cavity 321 fits the relay 312 can be constrained and reduced, thereby helping reduce the design margin, space waste, and occupied space of the power distribution apparatus 30, and being conducive to miniaturization and lightweight of the power distribution apparatus 30.

Referring to FIG. 4, FIG. 7, and FIG. 8, in some embodiments of the present application, there is a first gap 322 between the relay 312 and at least part of the inner wall 3211.

It should be noted that, the inner wall 3211 of the accommodating cavity 321 includes various walls that participate in enclosing and forming the accommodating cavity 321. The relay 312 may form the first gap 322 with one wall. The relay 312 may also form the first gap 322 with at least two walls. Of course, the first gaps 322 between the relay 312 and different walls may be arranged in the same manner or in different manners. The wall forming the first gap 322 with the relay 312 may form the first gap 322 with the relay 312 by abutting against the relay 312 partially, or may form the first gap 322 with the relay 312 by abutting against the relay entirely (that is, the entire wall).

By adopting the above solution, during the assembling of the relay 312 being picked and placed in the accommodating cavity 321, an assembling margin may be formed through the first gap 322 between the relay 312 and at least part of the inner wall 3211, which provides an assembling space to facilitate smooth picking and placing of the relay 312 in the accommodating cavity 321, thereby improving the assembling convenience and assembling efficiency between the relay 312 and the accommodating cavity 321. When the relay 312 is placed in the accommodating cavity 321, a connection space may be formed through the first gap 322 between the relay 312 and at least part of the inner wall 3211, so that a mutual connection relationship can be established between the relay 312 and the accommodating cavity 321 at the connection space, thereby facilitating the relay 312 to be stably and reliably fixed to the accommodating cavity 321.

Referring to FIG. 4, FIG. 7, and FIG. 8, in some embodiments of the present application, the first gap 322 is configured to be filled with structural adhesive (not shown), and the relay 312 is bonded to at least part of the inner wall 3211 by the structural adhesive.

It should be noted that, when the relay 312 has been placed in the accommodating cavity 321, the first gap 322 can be filled with the structural adhesive, so that the relay 312 and the corresponding part of the inner wall 3211 can be bonded and fixed through the structural adhesive. The structural adhesive refers to an adhesive suitable for bonding strong structural parts. The first gap 322 may be completely filled with the structural adhesive, or may be partially filled with the structural adhesive.

By adopting the above solution, when the relay 312 has been placed in the accommodating cavity 321, the connection space can be formed through the first gap 322 between the relay 312 and at least part of the inner wall 3211, for being filled with the structural adhesive, so that the relay 312 and the corresponding part of the inner wall 3211 can be reliably and firmly bonded together by the structural adhesive. Based on this, the fixing effect of the accommodating cavity 321 for the relay 312 can be effectively guaranteed and enhanced, which is conducive to stabilizing the mounting state of the relay 312 in the accommodating cavity 321, especially stabilizing the state of the relay 312 in the accommodating cavity 321 reliably when the relay 312 vibrates during operation. Furthermore, since the first gap 322 can be used to be filled with the structural adhesive, the first gap 322 may not constitute a space margin after the accommodating cavity 321 fits the relay 312, thereby reducing the design margin, space waste, and occupied space of the power distribution apparatus 30, which may be conducive to the miniaturization and lightweight of the power distribution apparatus 30.

In some embodiments, while guaranteeing that the first gap 322 meets the requirements of assembling space and connection space, the thickness of the first gap 322 can be reduced accordingly. In particular, the thickness of the first gap 322 can be made smaller than the thickness of each side wall of the shell structure of the shell relay of the existing power distribution apparatus. For example, assuming that the thickness of each side wall of the shell structure of the shell relay of the existing power distribution apparatus is about 2.0 mm, the thickness of the first gap 322 can be made greater than 0 mm and smaller than 2.0 mm. For example, the thickness may be 0.5 mm, 1.0 mm, 1.5 mm, 1.7 mm, 1.9 mm, or the like. The thickness of the first gap 322 refers to the minimum distance dimension of the first gap 322 from the corresponding wall to the corresponding side of the relay 312. Based on this, it can be guaranteed that the power distribution apparatus 30 provided in this embodiment is capable of saving a certain amount of space margin compared to the existing power distribution apparatus, thereby reducing the design margin, space waste and occupied space of the power distribution apparatus 30, which can be conducive to the miniaturization and lightweight of the power distribution apparatus 30.

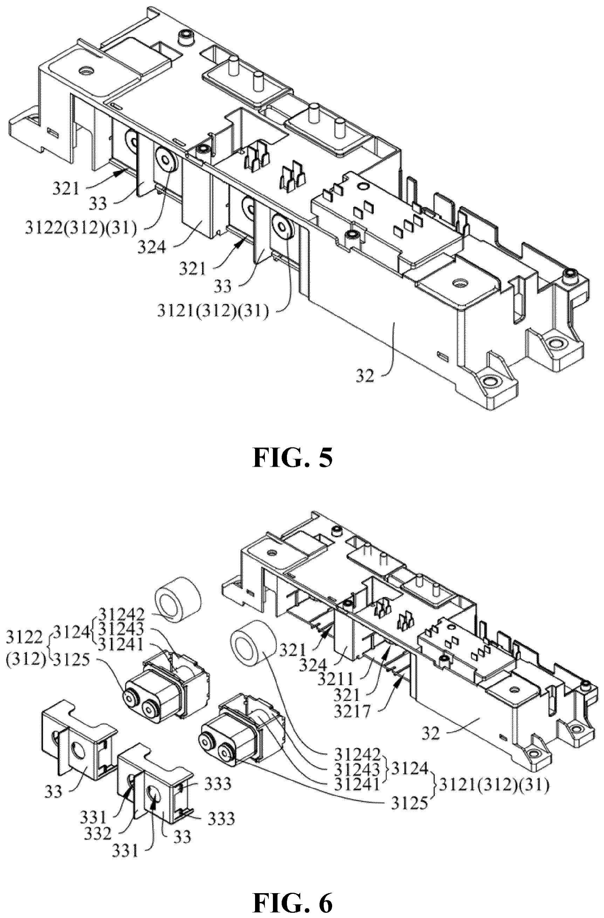

Referring to FIG. 5, FIG. 7, and FIG. 8, in some embodiments of the present application, the inner wall 3211 is provided with a protrusion structure 323, and the inner wall 3211 abuts against the relay 312 through at least part of the protrusion structure 323.

It should be noted that, the inner wall 3211 of the accommodating cavity 321 includes various walls that participate in enclosing and forming the accommodating cavity 321. The protrusion structure 323 may be arranged on one of the walls, or the protrusion structure 323 may be arranged on at least two walls. In particular, the protrusion structure 323 may be arranged on the wall that abuts against the relay 312. The inner wall 3211 may abut against the relay 312 through a portion or all of the protrusion structures 323.

By adopting the above solution, the inner wall 3211 of the accommodating cavity 321 can be provided with the protrusion structure 323, so that at least part of the protrusion structure 323 abuts against the relay 312, thereby guaranteeing and enhancing the position-limiting and positioning effects for the relay 312. Based on this, it is conducive to stabilizing the mounting state of the relay 312 in the accommodating cavity 321, especially stabilizing the state of the relay 312 in the accommodating cavity 321 reliably when the relay 312 vibrates during operation, thereby reducing the risk of the relay 312 being detached from the accommodating cavity 321, and being capable of guaranteeing and improving the mounting stability and operation reliability of the relay 312. On this basis, a contact area between the inner wall 3211 of the accommodating cavity 321 and the relay 312 can be reduced accordingly. Based on this, a friction between the relay 312 and the inner wall 3211 can be effectively reduced during the assembling of the relay 312 being picked and placed in the accommodating cavity 321, thereby improving the assembling convenience between the relay 312 and the accommodating cavity 321.

Furthermore, when the inner wall 3211 abuts against the relay 312 through at least part of the protrusion structure 323, the first gap 322 may be formed between the relay 312 and a region of the inner wall 3211 where the protrusion structure 323 is not provided. Therefore, by adopting the above solution, it is further conducive for the inner wall 3211 to abut against the relay 312 partially (that is, by at least part of the protrusion structure 323) to form the first gap 322 with the relay 312 partially (that is, with the region where the protrusion structure 323 is not provided). Based on this, during the assembling of the relay 312 being picked and placed in the accommodating cavity 321, the assembling margin can be formed by the first gap 322 to provide an assembling space, thereby improving the assembling convenience between the relay 312 and the accommodating cavity 321. Moreover, when the relay 312 has been placed in the accommodating cavity 321, the connection space can further be formed through the first gap 322, so as to stably and reliably fix the relay 312 to the accommodating cavity 321.

Referring to FIG. 5, FIG. 7, and FIG. 8, in some embodiments of the present application, the accommodating cavity 321 has an opening 3217. The inner wall 3211 includes a bottom wall 3212, a top wall 3213, a first side wall 3214, a second side wall 3215, and a third side wall 3216. The bottom wall 3212 is used to support the relay 312, and the top wall 3213 is arranged opposite to the bottom wall 3212. The first side wall 3214 is arranged opposite to the second side wall 3215. The third side wall 3216 is arranged opposite to the opening 3217.

It should be noted that, the accommodating cavity 321 has an opening 3217, and the opening 3217 of the accommodating cavity 321 allows the relay 312 to be picked and placed in the accommodating cavity 321. The inner wall 3211 of the accommodating cavity 321 includes the bottom wall 3212, the top wall 3213, the first side wall 3214, the second side wall 3215, and the third side wall 3216 which participate in enclosing and forming the accommodating cavity 321, constituting the other five sides of the accommodating cavity 321 except the opening 3217. The bottom wall 3212 refers to a wall mainly used to support the relay 312. The top wall 3213 refers to a wall arranged opposite to the bottom wall 3212, and is used to cooperate with the bottom wall 3212 to position-limit the relay 312. The third side wall 3216 refers to a wall arranged opposite to the opening 3217, and is used to position-limit and position the relay 312 in a direction away from the opening 3217, and in particular to prevent the relay 312 from being detached from the accommodating cavity 321 in a direction away from the opening 3217. The first side wall 3214 and the second side wall 3215 refer to the remaining two walls arranged opposite to each other, and the first side wall 3214 and the second side wall 3215 are used together to position-limit the relay 312.

By adopting the above solution, it is convenient to pick and place the relay 312 in the accommodating cavity 321 through the opening 3217. It is also convenient to achieve position-limiting and wrapping protection for the relay 312 in a plurality of directions through the bottom wall 3212, the top wall 3213, the first side wall 3214, the second side wall 3215, and the third side wall 3216 when the relay 312 has been placed in the accommodating cavity 321, thereby guaranteeing and improving the mounting stability of the relay 312 in the accommodating cavity 321, and guaranteeing and improving effects such as accommodating, position-limiting, fixing, and protecting of the accommodating cavity 321 for the relay 312.

Referring to FIG. 6, FIG. 7, and FIG. 8, in some embodiments of the present application, at least some walls among the bottom wall 3212, the top wall 3213, the first side wall 3214, the second side wall 3215, and the third side wall 3216 are provided with the protrusion structures 323.

It should be noted that, among the bottom wall 3212, the top wall 3213, the first side wall 3214, the second side wall 3215, and the third side wall 3216, some of the walls may be provided with the protrusion structure 323, or all of the walls may be provided with the protrusion structure 323. The wall provided with the protrusion structure 323 may abut against the relay 312 through at least part of the protrusion structure 323, or may form the first gap 322 with the relay 312 through a region where the protrusion structure 323 is not provided.

By adopting the above solution, during the assembling of the relay 312 being picked and placed in the accommodating cavity 321, at least some walls among the bottom wall 3212, the top wall 3213, the first side wall 3214, the second side wall 3215, and the third side wall 3216 can reduce a contact area between the wall and the relay 312 through the provided protrusion structure 323, so as to reduce a friction between the wall and the relay 312. Moreover, the first gap 322 can be formed between the relay 312 and the region where the protrusion structure 323 is not provided, so as to form the assembling margin through the first gap 322 to provide the assembling space. Therefore, the assembling convenience between the relay 312 and the accommodating cavity 321 can be improved.

By adopting the above solution, when the relay 312 has been placed in the accommodating cavity 321, at least some walls among the bottom wall 3212, the top wall 3213, the first side wall 3214, the second side wall 3215, and the third side wall 3216 can abut against the relay 312 through at least part of the protrusion structure 323, so as to guarantee and enhance the position-limiting and positioning effects for the relay 312. Moreover, the connection space can be formed through the first gap 322, so as to facilitate the relay 312 to be stably and reliably fixed in the accommodating cavity 321. Therefore, the mounting stability of the relay 312 in the accommodating cavity 321 can be improved.

Referring to FIG. 6, FIG. 7, and FIG. 8, in some embodiments of the present application, the protrusion structures 323 provided on the bottom wall 3212, the top wall 3213, the first side wall 3214, and the second side wall 3215 are first protrusions 3231, and the first protrusions 3231 are arranged to extend in a direction away from the opening 3217.

It should be noted that if the bottom wall 3212, the top wall 3213, the first side wall 3214, and the second side wall 3215 are provided with the protrusion structures 323, the provided protrusion structures 323 are the first protrusions 3231. The first protrusion 3231 extends in the direction away from the opening 3217, that is, the first protrusion 3231 is arranged to extend in a direction close to the third side wall 3216.

By adopting the above solution, during the assembling of the relay 312 being picked and placed in the accommodating cavity 321, at least some walls among the bottom wall 3212, the top wall 3213, the first side wall 3214, and the second side wall 3215 can follow a disassembling and assembling direction of the relay 312 and the accommodating cavity 321 through the first protrusion 3231 extending in the direction away from the opening 3217, so as to reduce the friction between the wall and the relay 312, especially reduce the friction in directions other than the disassembling and assembling direction. Therefore, the assembling convenience and assembling efficiency between the relay 312 and the accommodating cavity 321 can be improved while guaranteeing the position-limiting effect for the relay 312.

Referring to FIG. 6, FIG. 7, and FIG. 8, in some embodiments of the present application, the protrusion structure 323 provided on the third side wall 3216 is a second protrusion 3232. There are at least two second protrusions 3232, and the second protrusions 3232 are cross-connected.

It should be noted that if the third side wall 3216 is provided with the protrusion structures 323, the provided protrusion structures 323 are the second protrusions 3232. There are at least two second protrusions 3232. The second protrusions 3232 are cross-connected, that is, extension directions of the second protrusions 3232 are different, so that the second protrusions 3232 can be cross-connected, for example, can be cross-connected vertically and horizontally.

When the second protrusions 3232 are cross-connected, cells may be formed between the second protrusions 3232, and when at least part of the second protrusions 3232 abut against the relay 312, the first gap 322 may be formed in the cells.

By adopting the above solution, when the relay 312 has been placed in the accommodating cavity 321, the third side wall 3216 can abut against the relay 312 through at least part of the cross-connected second protrusions 3232 to enhance the position-limiting and positioning effects for the relay 312. The first gap 322 can be formed through cells between the second protrusions 3232 to form a connection space through the first gap 322. Therefore, it may be conducive to improving the mounting stability of the relay 312 in the accommodating cavity 321.

Referring to FIG. 4, FIG. 5, and FIG. 6, in some embodiments of the present application, the accommodating cavity 321 has an opening 3217. The power distribution apparatus 30 includes a covering member 33. The covering member 33 is connected to the base 32 and used to block the opening 3217.

It should be noted that, the accommodating cavity 321 has the opening 3217, and the opening 3217 of the accommodating cavity 321 allows the relay 312 to be picked and placed in the accommodating cavity 321. The covering member 33 is a member for blocking the opening 3217. When the relay 312 has been placed in the accommodating cavity 321 and the relay 312 has been connected to the inner wall 3211 of the accommodating cavity 321, the covering member 33 may be connected to the base 32 to block the opening 3217 through the covering member 33. The connection between the covering member 33 and the base 32 may be a fixed connection or a detachable connection. The covering member 33 may be arranged in one-to-one correspondence with the opening 3217 of the accommodating cavity 321, so that the covering member 33 may be used to block the opening 3217 in a one-to-one manner. Of course, in other embodiments, the covering member 33 can be used to block at least two openings 3217.

By adopting the above solution, when the relay 312 has been placed in the accommodating cavity 321 and the relay 312 has been connected to the inner wall 3211 of the accommodating cavity 321, the opening 3217 of the accommodating cavity 321 can be blocked by the covering member 33 connected to the base 32. Based on this, on the one hand, the covering member 33 can cooperate with the base 32 to form all-round protection for the relay 312 in the accommodating cavity 321, thereby guaranteeing and improving the protection effect of the power distribution apparatus 30 on the relay 312, and guaranteeing and extending the service life of the relay 312 and the power distribution apparatus 30. On the one hand, the covering member 33 can reliably prevent the relay 312 from being detached from the opening 3217 of the accommodating cavity 321, and in particular prevent the relay 312 from being detached from the accommodating cavity 321 due to vibration generated during operation, thereby guaranteeing and improving the mounting stability and mounting reliability of the relay 312 by the power distribution apparatus 30. On the one hand, the covering member 33 can reliably prevent external devices from contacting, colliding with, and damaging the relay 312, thereby guaranteeing and extending the service life of the relay 312 and the power distribution apparatus 30, and to a certain extent also reducing the safety hazards of the power distribution apparatus 30.

Referring to FIG. 4, FIG. 5, and FIG. 6, in some embodiments of the present application, the covering member 33 has a through hole 331 penetrated for a contact 3125 of the relay 312 to pass through.

It should be noted that the relay 312 includes the contact 3125, and the contact 3125 is used to be connected to a high-voltage circuit. By closing or opening the contact 3125, on/off of the high-voltage circuit can be controlled.

When the relay 312 is arranged with its contact 3125 facing the opening 3217, the covering member 33 is provided with a through hole 331, and the through hole 331 penetrates the covering member 33 in a direction away from the accommodating cavity 321. The through hole 331 can be used to allow the contact 3125 of the relay 312 to pass through, so that the contact 3125 is exposed from the covering member 33 and connected to the high-voltage circuit. The through hole 331 may be used to allow at least one contact 3125 to pass through.

By adopting the above solution, when the relay 312 is arranged with its contact 3125 facing toward the side of the opening 3217 and the covering member 33 blocks the opening 3217 of the accommodating cavity 321, the covering member 33 may be provided with a through hole 331 for the contact 3125 of the relay 312 to pass through the through hole 331, so that the contact 3125 of the relay 312 is exposed from the covering member 33 and connected to a high-voltage circuit to control on/off of the high-voltage circuit. Based on this, respective functions of the covering member 33 and the relay 312 can be taken into consideration, thereby guaranteeing the use performance of the power distribution apparatus 30.

Of course, in other embodiments, the relay 312 may be arranged with its contact 3125 facing toward the third side wall 3216. In this case, a corresponding hole structure may be arranged on the third side wall 3216 for the contact 3125 of the relay 312 to pass through.

Referring to FIG. 4, FIG. 5, and FIG. 6, in some embodiments of the present application, each covering member 33 is provided with at least one through hole 331, each relay 312 has at least two contacts 3125, each through hole 331 corresponds to at least one contact 3125, and each through hole 331 is used to allow the corresponding contact 3125 to pass through.

It should be noted that, in some cases, the relay 312 is provided with at least two contacts 3125, so that the contacts 3125 can be closed or opened respectively to jointly control the on/off of the high-voltage circuit.

The covering member 33 may be provided with at least one through hole 331. In some embodiments, the number of the arranged through holes 331 is equal to the number of the arranged contacts 3125 of the relay 312, so that the through holes 331 can be arranged in one-to-one correspondence with the contacts 3125 of the relay 312, and therefore, the through holes 331 can allow the contacts 3125 of the relay 312 to pass through in a one-to-one manner. In other embodiments, the number of the arranged through holes 331 is less than the number of the arranged contacts 3125 of the relay 312. In this case, each through hole 331 corresponds to at least one contact 3125, some through holes 331 each correspond to at least two contacts 3125, and the through holes 331 can allow the corresponding contacts 3125 to pass through.

By adopting the above solution, when the relay 312 is arranged with its contact 3125 facing toward the side of the opening 3217 and the covering member 33 blocks the opening 3217 of the accommodating cavity 321, the covering member 33 can be provided with at least one through hole 331, and at least two contacts 3125 of the relay 312 are exposed one-to-one or one-to-many through the through hole 331. Based on this, the respective functions of the covering member 33 and the relay 312 can be taken into consideration, which can facilitate the various contacts 3125 of the relay 312 to be connected to the high-voltage circuit and work together to control on/off of the high-voltage circuit. In particular, when each through hole 331 corresponds to one contact 3125, the contacts 3125 of the relay 312 can be separated in different through holes 331, so as to improve the insulation performance between the contacts 3125 of the relay 312 accordingly, thereby reducing the risk of short circuit and reducing the safety hazards of the power distribution apparatus 30.

Referring to FIG. 4, FIG. 5, and FIG. 6, in some embodiments of the present application, the covering member 33 is provided with a barrier structure 332 for separating two adjacent contacts 3125 of the relay 312.

It should be noted that, in some cases, the relay 312 is provided with at least two contacts 3125, so that the contacts 3125 can be closed or opened respectively to jointly control the on/off of the high-voltage circuit.

On this basis, the covering member 33 may be provided with at least one barrier structure 332. The barrier structure 332 includes an insulating material, has an insulation performance, and can play an insulating role. When each contact 3125 of the relay 312 passes through the corresponding through hole 331 of the covering member 33, the barrier structure 332 can insulate and separate the contacts 3125 on both sides thereof, thereby increasing a creepage distance between the contacts 3125 on both sides of the barrier structure 332 and improving the insulation performance between the contacts 3125 on both sides of the barrier structure 332. At least one barrier structure 332 may be arranged between each group of two adjacent contacts 3125.

The barrier structure 332 may be but is not limited to in a plate shape.

The barrier structure 332 may be arranged on one side of the covering member 33 away from the accommodating cavity 321, or may be arranged on one side of the covering member 33 facing the accommodating cavity 321.

The barrier structure 332 may be an integrally formed component of the covering member 33, or a separately formed component.

By adopting the above solution, when each contact 3125 of the relay 312 passes through the corresponding through hole 331 of the covering member 33, the covering member 33 can insulate and separate two adjacent contacts 3125 through the barrier structure 332 provided between the two adjacent contacts 3125. In this way, the creepage distance between two adjacent contacts 3125 can be effectively increased, and the insulation performance between two adjacent contacts 3125 can be effectively improved, thereby reducing the risk of short circuit and reducing the safety hazards of the power distribution apparatus 30.

Referring to FIG. 4, FIG. 5, and FIG. 6, in some embodiments of the present application, the power distribution apparatus 30 includes a shielding member 34. The shielding member 34 is arranged on one side of the covering member 33 away from the accommodating cavity 321, and is used to shield the contact 3125 of the relay 312.

It should be noted that the shielding member 34 is a case component of the power distribution apparatus 30 and has a certain structural strength and rigidity. The shielding member 34 is arranged on one side of the covering member 33 away from the accommodating cavity 321. The shielding member 34 may be but is not limited to in a plate shape. The shielding member 34 may be used to shield the covering member 33 and the contact 3125 of the relay 312 exposed from the through hole 331 of the covering member 33, so as to guarantee that the contact 3125 of the relay 312 is not exposed to the outside of the power distribution apparatus 30. The shielding member 34 may be optionally connected to the base 32 to stabilize and fix the mounting position and mounting state of the shielding member 34. The shielding member 34 can shield the various covering members 33 and the contacts 3125 of the various relays 312. Of course, in other embodiments, the shielding member 34 may shield the covering member 33 and the contact 3125 of the corresponding relay 312 in a one-to-one manner.

By adopting the above solution, on the basis of taking into account the respective functions of the covering member 33 and the relay 312, the covering member 33 and the contacts 3125 of the relay 312 exposed from the through hole 331 of the covering member 33 can be shielded by the shielding member 34 arranged on the side of the covering member 33 away from the accommodating cavity 321, which especially ensures that the contacts 3125 of the relay 312 are not exposed to the outside of the power distribution apparatus 30. Based on this, on the one hand, the shielding member 34 can be used to protect the covering member 33 and the contacts 3125 of the corresponding relay 312 to guarantee and extend the service life of the relay 312 and the power distribution apparatus 30. On the other hand, the shielding member 34 can reliably prevent human hands or external devices from contacting with the contacts 3125 of the relay 312 to conduct electricity, thereby reducing the safety hazards of the power distribution apparatus 30 and improving the use performance of the power distribution apparatus 30.

Referring to FIG. 4, FIG. 5, and FIG. 6, in some embodiments of the present application, the covering member 33 is connected to the inner wall 3211 of the accommodating cavity 321 by snaps 333.

It should be noted that the snap 333 is arranged on at least one side of the covering member 33. For example, in some embodiments, the snaps 333 are arranged on two opposite sides of the covering member 33. The covering member 33 can be connected to the inner wall 3211 of the accommodating cavity 321 by corresponding snap connection through the snap 333, so as to realize a convenient and quick detachable connection to the base 32.

By adopting the above solution, when the relay 312 has been placed in the accommodating cavity 321 and the relay 312 has been connected to the inner wall 3211 of the accommodating cavity 321, the covering member 33 can be aligned and fit to the side of the relay 312 close to the opening 3217, and the snap 333 of the covering member 33 is correspondingly snap-connected to the inner wall 3211 of the accommodating cavity 321, so as to conveniently and quickly realize the detachable connection of the covering member 33 to the base 32. Based on this, the connection convenience and connection reliability between the covering member 33 and the base 32 can be guaranteed and improved, and it can be guaranteed that the covering member 33 is capable of accurately and reliably block the opening 3217 of the accommodating cavity 321.

Of course, in other embodiments, the covering member 33 may be connected to the base 32 by bolts or the like.

Referring to FIG. 4, FIG. 5, and FIG. 6, in some embodiments of the present application, there are at least two accommodating cavities 321, there are at least two relays 312, and at least some of the relays 312 are mounted in the accommodating cavities 321 in a one-to-one manner.

It should be noted that the base 32 is provided with at least two accommodating cavities 321. The accommodating cavities 321 may be flexibly arranged on the base 32. The number of the arranged relays 312 may be greater than or equal to the number of the arranged accommodating cavities 321, so that at least some of the relays 312 may be fixedly mounted in each accommodating cavity 321 in a one-to-one manner.

By adopting the above solution, the base 32 can fix and mount at least two relays 312 in a one-to-one manner through the at least two accommodating cavities 321. Based on this, it can be guaranteed that the base 32 is capable of, through each accommodating cavity 321, playing the functions such as accommodating, position-limiting, fixing, and protecting for each relay 312 fixedly mounted in the accommodating cavity 321. At the same time, shell structures of the at least two relays 312 can be omitted, thereby making the overall layout of the base 32 and the relays 312 compact to a great extent, which is more conducive to the integration, miniaturization, lightweight, and simplification of the power distribution apparatus 30.

Referring to FIG. 4, FIG. 5, and FIG. 6, in some embodiments of the present application, the base 32 is provided with at least one insulating structure 324. The insulating structure 324 is arranged between two adjacent accommodating cavities 321 to separate the contacts 3125 of the corresponding two relays 312.

It should be noted that at least two accommodating cavities 321 are provided, and the accommodating cavities 321 can be flexibly arranged on the base 32. Due to the compact layout, in some cases, there are at least two accommodating cavities 321 arranged adjacent to each other, and the shellless relays in the two adjacent accommodating cavities 321 may be close to each other, especially, the contacts 3125 of the two adjacent relays 312 may be close to each other.

Based on this, the base 32 may be provided with the insulating structure 324 between the two adjacent accommodating cavities 321. At least one insulating structure 324 may be arranged between each group of two adjacent accommodating cavities 321. The insulating structure 324 includes an insulating material, has an insulation performance, and can play an insulating role. The insulating structure 324 can insulate and separate the accommodating cavities 321 on both sides thereof, and in particular can insulate and separate the two relays 312 correspondingly mounted in the two accommodating cavities 321, and in particular can insulate and separate the contacts 3125 of the corresponding two relays 312, thereby improving the insulation performance between the contacts 3125 of the relays 312 located on opposite sides of the insulating structure 324.

The structure of the insulating structure 324 can be designed in a variety of ways. For example, the insulating structure 324 can be a frame-shaped structure connected end to end.

The insulating structure 324 is an integrally formed component of the base 32, or a separately formed component.

By adopting the above solution, the base 32 may be provided with the insulating structure 324 between two adjacent accommodating cavities 321, so as to insulate and separate the two adjacent accommodating cavities 321 by the insulating structure 324. Therefore, two relays 312 correspondingly mounted in the two accommodating cavities 321 can be insulated and separated by the insulating structure 324, and in particular, contacts 3125 of the two corresponding relays 312 can be insulated and separated. In this way, the insulation performance between the contacts 3125 of two adjacent shellless relays can be effectively improved, the risk of short circuit can be reduced, and the reliability and safety of using the power distribution apparatus 30 can be improved.

Referring to FIG. 4, FIG. 9, and FIG. 10, in some embodiments of the present application, the power distribution apparatus 30 includes an electrical component 31 and a cover body 35. The electric component 31 includes a relay 312. There are at least two electrical components 31, and both are mounted on the base 32. The cover body 35 is arranged on the same side of each electrical component 31 and connected to the base 32. A circuit element 36 is arranged on one side of the cover body 35 facing each electrical component 31, for electrically connecting to each electrical component 31.

It should be noted that the electrical component 31 may refer to any electrical element in the power distribution apparatus 30. At least two electrical components 31 are provided. The electrical components 31 may include a relay 312, a current sensor 313, a fuse, an insurance device 314, a pre-charging resistor 315, or the like. The electrical components 31 are mounted on the base 32 and have a stable mounting position and mounting state relative to the base 32.

The relay 312 is an electrical control device, which is an electrical component that, when a change in an input quantity (excitation quantity) reaches a specified requirement, causes a predetermined step change in a controlled quantity in an electrical output circuit. The relay 312 may include a main positive relay 3121, a main negative relay 3122, a pre-charging relay 3123, or the like.

The current sensor 313 is a detection apparatus that can sense information of a measured current, convert the detected and sensed information into electrical signals or information in other desired forms conforming to certain standards and requirements according to a certain rule and output them, to meet requirements for transmitting, processing, storing, displaying, recording, and controlling the information. The current sensor 313 may include a shunt 3131, a Hall current sensor 3132, and the like.

The fuse is an electrical appliance that, when a current flowing through the fuse exceeds a specified value, a fuse-element fuses with heat generated by itself, thereby disconnecting a circuit.

The insurance device 314, also known as a fuse, is a safety component used to protect the electrical component 31 from damage when a circuit is overloaded (such as having a excessive current or excessive voltage), short-circuited, or the like. In some embodiments, the insurance device 314 may be used as the fuse.

The pre-charging resistor 315 is a component used to limit the magnitude of a charging current in an initial stage of charging (that is, charging a capacitor by a power source) to reduce the risk of the charging current causing a large impact on a component such as the relay 312.

It should be further noted that the cover body 35 is a case component of the power distribution apparatus 30 and used for covering the base 32, and has a certain structural strength and rigidity. The cover body 35 is connected to one side of the base 32 and stabilizes its mounting position and mounting state relative to the base 32. The cover body 35 and the base 32 may be connected in a detachable manner or a fixed manner.

The cover body 35 and the base 32 may together enclose an inner space. At least one electrical component 31 may be arranged in the inner space. For example, in some embodiments, the pre-charging relay 3123 and the pre-charging resistor 315 may be mounted in the space enclosed by the cover body 35 and the base 32.

The cover body 35 is arranged on the same side of each electrical component 31. The circuit element 36 is provided on one side of the cover body 35 facing each electrical component 31. The circuit element 36 can be configured to be electrically connected to each electrical component 31 to establish the electrical connection relationship required by each electrical component 31, thereby guaranteeing that the power distribution apparatus 30 is capable of achieving the required functions.

By adopting the above solution, by mounting the electrical components 31 on the base 32, on the one hand, it can facilitate the planning, optimization, and compactness of the layout of the electrical components 31, thereby facilitating compactness of the overall layout of the base 32 and the electrical components 31, and facilitating the integration, miniaturization, lightweight, and simplification of the power distribution apparatus 30. On the other hand, the base 32, in combination with the cover body 35 connected to the base 32, can together form reliable protection for the electrical components 31 mounted on the base 32, thereby guaranteeing and extending the service life of the electrical components 31 and the power distribution apparatus 30.

By adopting the above solution, by integrating the circuit element 36 on the side of the cover body 35 facing the electrical components 31, the cover body 35 can provide better protection for the circuit elements 36, so as to reduce the risk of damage to the circuit elements 36, thereby guaranteeing and extending the service life of the circuit elements 36. Furthermore, when the cover body 35 is assembled to the base 32, accurate alignment and electrical connection fitting between the circuit elements 36 and the electrical components 31 can be accomplished simultaneously, thereby reliably constructing electrical connection relationships required by the electrical components 31 through the circuit elements 36, and guaranteeing that the power distribution apparatus 30 is capable of achieving the required functions. Moreover, the number of assembling steps can further be reduced, thereby improving the connection convenience and connection reliability between the circuit elements 36 and the electrical components 31, and improving the assembling convenience and assembling efficiency of the power distribution apparatus 30.

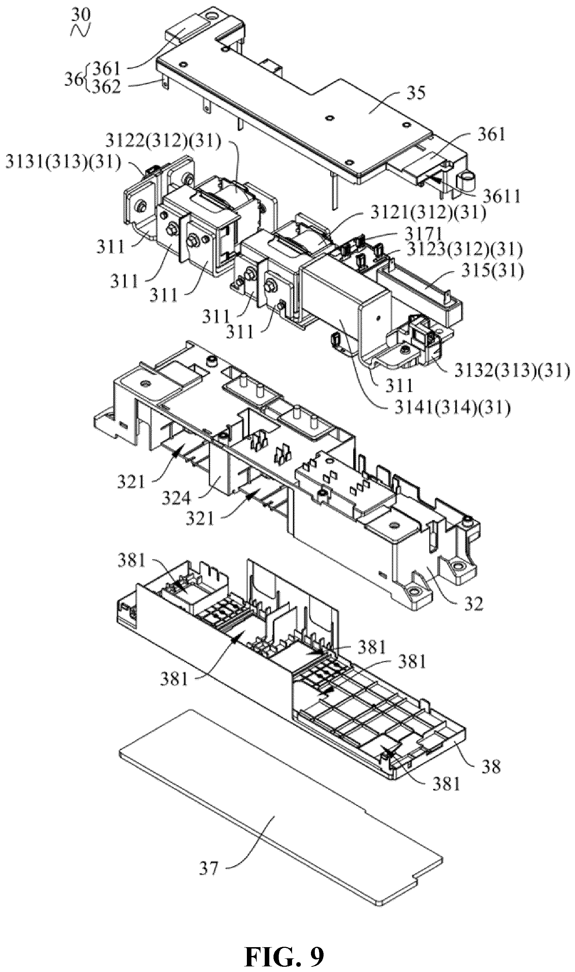

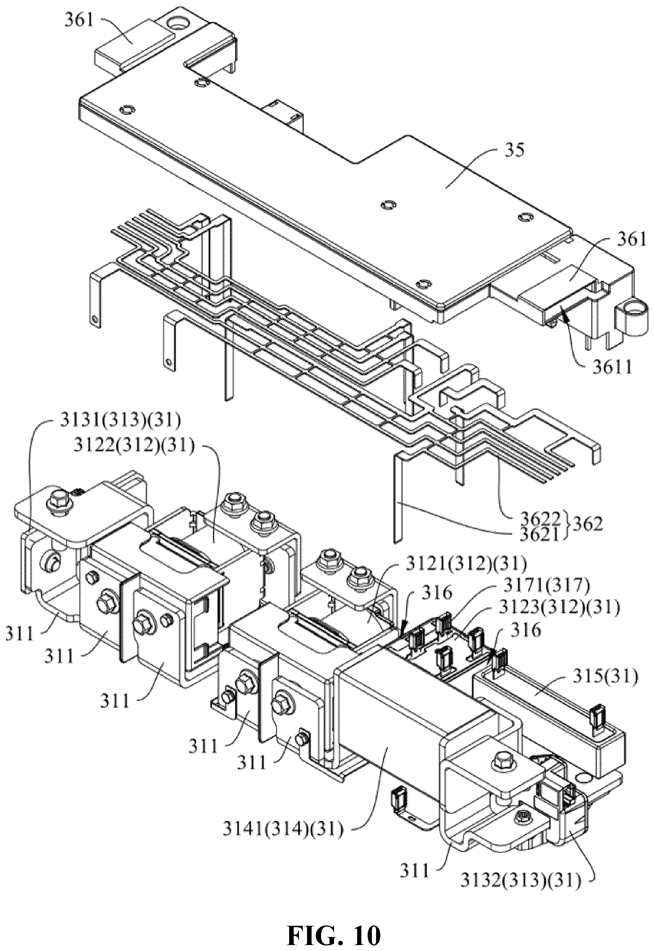

Referring to FIG. 9 and FIG. 10, in some embodiments of the present application, a gap between an electrical component 31 and an electrical component 31 adjacent thereto is a second gap 316. The electrical component 31 is provided with a first connecting element 317. The first connecting element 317 includes a first connecting portion 3171 for being detachably connected to the circuit element 36. The first connecting portion 3171 is located outside the second gaps 316 of the corresponding electrical component 31.

It should be noted that the electrical components 31 can be arranged flexibly. For any electrical component 31, a gap between it and an electrical component 31 adjacent thereto can serve as the second gap 316. Of course, for any electrical component 31, when there are at least two electrical components 31 arranged adjacent thereto distributed around it, it may have at least two second gaps 316. The sizes of the second gaps 316 of the same electrical component 31 may set to be the same or different, and the sizes of the second gaps 316 of different electrical components 31 may set to be the same or different.

It should be further noted that the electrical component 31 is provided with at least one first connecting element 317, and the first connecting element 317 is configured to be electrically connected to the circuit element 36. One end of the first connecting element 317 is mechanically and electrically connected to the electrical component 31, and the other end of the first connecting element 317 is provided with the first connecting portion 3171. The first connecting portion 3171 is configured to be mechanically and electrically connected to the circuit element 36 in a detachable manner. The first connecting portion 3171 can achieve detachable mechanical and electrical connection to the circuit element 36 by means of, but not limited to, plug-in, snap-on, elastic abutment, and the like.

The first connecting portion 3171 is located outside the second gaps 316 of the corresponding electrical component 31, that is, the first connecting portion 3171 and the second gaps 316 of the corresponding electrical component 31 are spatially staggered, the first connecting portion 3171 does not occupy the space of the second gaps 316 of the electrical component 31, and the first connecting portion 3171 is located outside the second gaps 316 of the corresponding electrical component 31. Based on this, on the one hand, the first connecting portion 3171 can be arranged outside the second gaps 316 of the corresponding electrical component 31, so that a connection operation of the first connecting portion 3171 can be performed in the space outside the second gaps 316 of the corresponding electrical component 31, thereby guaranteeing and improving the operational convenience of connecting and disconnecting the first connecting portion 3171. On the other hand, the second gaps 316 of the electrical component 31 neither need to have the first connecting portion 3171 arranged, nor need to provide a connection operation space for the first connecting portion 3171, the sizes of the second gaps 316 of the electrical component 31 can be compressed as needed, which can help compress the gap between the electrical component 31 and the electrical component 31 arranged adjacent thereto, thereby facilitating compactness of the overall layout of the electrical components 31.

By adopting the above solution, in the case that the gap between each electrical component 31 and the adjacent electrical component 31 is defined as the second gap 316, by arranging the first connecting portion 3171 outside the second gaps 316 of the corresponding electrical component 31, on the one hand, it is convenient to perform a connection operation of the first connecting portion 3171 in the space outside the second gaps 316 of the corresponding electrical component 31, thereby guaranteeing and improving the operational convenience of connecting and disconnecting the first connecting portion 3171. On the other hand, the second gaps 316 of the electrical components 31 neither need to provide an accommodation space for the first connecting portion 3171, nor need to provide a connection operation space for the first connecting portion 3171, thereby facilitating compressing the gap between the electrical component 31 and the adjacent electrical component 31 as needed, which facilitates compactness of the overall layout of the electrical components 31, thereby facilitating the formation of an integrated, compact, and miniaturized power distribution apparatus 30.

Referring to FIG. 9 and FIG. 10, in some embodiments of the present application, the circuit element 36 includes a connector 361 and a second connecting element 362. The connector 361 is embedded in the cover body 35, and a socket 3611 of the connector 361 is exposed outside the cover body 35. The second connecting element 362 includes a conductive connecting portion 3622 and a second connecting portion 3621. One end of the conductive connecting portion 3622 is connected to the connector 361, and the other end of the conductive connecting portion 3622 is connected to the second connecting portion 3621. The second connecting portion 3621 is arranged to bend toward the corresponding electrical component 31 for being detachably connected to the corresponding electrical component 31.

It should be noted that the connector 361 is a connection terminal for connecting to a component such as the battery unit 10 (as shown in FIG. 3). At least part of the connector 361 is embedded in the cover body 35, so that the mounting position and mounting state of the connector 361 relative to the cover body 35 are stable and firm. The socket 3611 of the connector 361 is exposed outside the cover body 35, so that a connection terminal of the component such as the battery unit 10 can be plugged into the socket 3611 to achieve electrical connection to the connector 361.

In some embodiments, the power distribution apparatus 30 may be provided with two connectors 361, where one connector 361 is used for high-voltage sampling and the other connector 361 is used for low-voltage control. Of course, in other embodiments, the power distribution apparatus 30 may be provided with only one connector 361, and the connector 361 integrates the high-voltage sampling and low-voltage control functions. Of course, in other embodiments, the power distribution apparatus 30 may also be provided with three or more connectors 361, and functions of the connectors 361 may set to be the same or different.

It should further be noted that, according to the number and positions of the electrical components 31 that the connector 361 needs to connect, the connector 361 can be connected to one or at least two second connecting elements 362. The second connecting element 362 includes a conductive connecting portion 3622, one end of the conductive connecting portion 3622 is electrically connected to the connector 361, and the other end of the conductive connecting portion 3622 is arranged to extend toward the electrical component 31 to be connected. An extension path of the conductive connecting portion 3622 may be a straight line, a curve, or the like.

At one end of the conductive connecting portion 3622 close to the corresponding electrical component 31, the second connecting element 362 may be bent to form a second connecting portion 3621. The conductive connecting portion 3622 and the corresponding second connecting portion 3621 may be integrally connected or separately connected. The second connecting portion 3621 is arranged to bend toward the corresponding electrical component 31, and is configured to be mechanically and electrically connected to the first connecting portion 3171 of the corresponding electrical component 31 in a detachable manner. The second connecting portion 3621 can achieve detachable mechanical and electrical connection to the first connecting portion 3171 by means of, but not limited to, plug-in, snap-on, elastic abutment, and the like.

By adopting the above solution, when the electrical components 31 are mounted in the power distribution apparatus 30, by connecting the connector 361 to the conductive connecting portion 3622 of the second connecting element 362, and detachably connecting the second connecting portion 3621 of the second connecting element 362 to the first connecting portion 3171 of the corresponding electrical component 31, the electrical connection between the connector 361 and the corresponding electrical component 31 can be achieved conveniently, quickly, and reliably. On this basis, the socket 3611 of the connector 361 can be exposed outside the power distribution apparatus 30 to facilitate electrical connection with the component such as the battery unit 10 through the socket 3611. Therefore, on the basis of integrating and protecting the connector 361, the electrical components 31, and other components in the power distribution apparatus 30, it is convenient to realize external connection to the component such as the battery unit 10 through the connector 361, so that it is convenient to provide high-voltage sampling, low-voltage control, and other functions for the externally connected battery unit 10 and other components by combining the electrical components 31 and the connector 361.

Referring to FIG. 9 and FIG. 10, in some embodiments of the present application, the conductive connecting portion 3622 includes at least one of a conductive sheet, a Flexible Printed Circuit board (FPC), and a Printed Circuit Board (PCB).

It should be noted that the conductive connecting portion 3622 refers to a portion of the second connecting element 362 that is connected between the connector 361 and the second connecting portion 3621 thereof. The conductive connecting portion 3622 may be, but is not limited to, a conductive sheet, an FPC, a PCB, and the like.

By adopting the above solution, the second connecting element 362 can replace a wiring harness with the conductive connecting portion 3622 to achieve the connection between the connector 361 and its second connecting portion 3621, thereby reducing the setting of the wiring harness, reducing the problems of wiring harness interference and wiring harness wear, guaranteeing and improving the structural reliability of the connector 361 and the second connecting element 362, and guaranteeing and improving the reliability and performance of using the power distribution apparatus 30.

Referring to FIG. 9 and FIG. 10, in some embodiments of the present application, the conductive connecting portion 3622 is embedded in the cover body 35.

It should be noted that at least part of the conductive connecting portion 3622 of the second connecting element 362 is embedded in the cover body 35, so that the mounting position and mounting state of the second connecting element 362 relative to the cover body 35 are stable and firm.

By adopting the above solution, the cover body 35 can provide better protection for a part of the conductive connecting portion 3622 embedded in the cover body, thereby reducing the risk such as interference, wear, and damage to the conductive connecting portion 3622, and extending the service life of the conductive connecting portion 3622 and the circuit elements 36. Furthermore, since the conductive connecting portion 3622 is embedded in the cover body 35, the mounting stability and mounting accuracy of the circuit element 36 relative to the cover body 35 can be guaranteed and improved. Based on this, when the cover body 35 is assembled to the base 32 and the electrical connection fitting between the circuit element 36 and each electrical component 31 is completed at the same time, the alignment accuracy between the circuit element 36 and each electrical component 31 can be effectively improved, thereby improving the connection convenience and connection reliability between the circuit element 36 and each electrical component 31.

Referring to FIG. 4, FIG. 9, and FIG. 10, in some embodiments of the present application, the cover body 35, the connector 361, and the conductive connecting portion 3622 form an integrated structure.

It should be noted that, based on the arrangements that "the connector 361 is embedded in the cover body 35" and that "the conductive connecting portion 3622 is embedded in the cover body 35", the cover body 35, the connector 361, and the conductive connecting portion 3622 can form an integrated structure through but not limited to one-piece molding processes such as one-piece injection molding and 3D printing.

By adopting the above solution, the cover body 35 as well as the connector 361 and the conductive connecting portion 3622 embedded in the cover body 35 can form the integrated structure. Based on this, the connection reliability, connection tightness, connection stability, and connection strength between the cover body 35 and the connector 361 and between the cover body and the conductive connecting portion 3622 can be effectively enhanced, the comprehensive structural strength of the cover body 35, the connector 361, and the conductive connecting portion 3622 can be effectively enhanced, the protective effect of the cover body 35 on the connector 361 and the conductive connecting portion 3622 can be effectively enhanced, the risk of wear and damage to the connector 361 can be reduced, and the risk such as interference and wear of the conductive connecting portion 3622 can be reduced.

By adopting the above solution, the assembling process between the cover body 35 and the connector 361, and between the cover body 35 and the conductive connecting portion 3622 can be simplified. During assembling of the cover body 35, it is also convenient to complete precise alignment between the second connecting portion 3621 of the second connecting element 362 and the first connecting portion 3171 of the corresponding electrical component 31, and complete electrical connection fitting between the second connecting portion 3621 and the corresponding first connecting portion 3171. That is, the connecting process between the second connecting element 362 and the electrical component 31 can be simplified, thereby effectively reducing the assembling steps, effectively guaranteeing and improving the reliability of the connection of the connector 361 to the electrical component 31, and effectively improving the assembling efficiency and structural reliability of the power distribution apparatus 30.

Referring to FIG. 3, FIG. 9, and FIG. 11, in some embodiments of the present application, the power distribution apparatus 30 includes an electrical component 31 and an insulating heat-conducting member 37. The electric component 31 includes a relay 312. The electrical component 31 is mounted on the base 32. One side of the insulating heat-conducting member 37 is connected to at least part of the electrical component 31 and the other side of the insulating heat-conducting member 37 is used to be connected to a heat exchange member 40. The insulating heat-conducting member 37 is configured to transfer heat from the electrical component 31 to the heat exchange member 40.

It should be noted that the electrical component 31 may refer to any electrical element in the power distribution apparatus 30. The electrical components 31 may include a relay 312, a current sensor 313, a fuse, an insurance device 314, a pre-charging resistor 315, or the like. The relay 312 may include a main positive relay 3121, a main negative relay 3122, a pre-charging relay 3123, or the like. The current sensor 313 may include a shunt 3131, a Hall current sensor 3132, and the like. In some embodiments, the insurance device 314 may be used as the fuse.

The electrical component 31 may be mounted on the base 32. Based on this, the electrical component 31 can be mounted and protected by the base 32, and the mounting position and mounting state of the electrical component 31 relative to the base 32 can be made stable and firm. Therefore, this can help guarantee and extend the service life of the electrical component 31. It is conducive for the electrical components 31 to stabilize their positions and states and establish required electrical connection relationships between them. Furthermore, when the mounting position and mounting state of the insulating heat-conducting member 37 relative to the base 32 are stable, the electrical component 31 and the insulating heat-conducting member 37 can be precisely and stably aligned, which facilitates accurate and reliable establishment of an insulating heat conductive connection relationship between the electrical component 31 and the insulating heat-conducting member 37.

It should also be noted that the heat exchange member 40 may refer to an external component used for performing heat exchange with the component such as the electrical component 31. The heat exchange member 40 has good heat-conducting performance, and is capable of quickly and reliably performing heat exchange with the electrical component 31, the insulating heat-conducting member 37, and other components, and quickly dissipate the heat. For example, the heat exchange member 40 may be a heat management component 41, or may be a box body 20 of the battery 1, or may be a vehicle body of a vehicle, or the like.

It should further be noted that the insulating heat-conducting member 37 is a component at least configured to transfer heat from the electrical component 31 to the heat exchange member 40. When the power distribution apparatus 30 is arranged on the heat exchange member 40, the insulating heat-conducting member 37 will be located between the electrical component 31 and the heat exchange member 40.

The insulating heat-conducting member 37 includes a heat-conducting material, has heat-conducting performance, and functions to conduct heat, that is, functions for heat exchange and thermal conduction effects. One side of the insulating heat-conducting member 37 is heat-conductively connected to at least part of the electrical component 31 and the other side of the insulating heat-conducting member 37 is heat-conductively connected to the heat exchange member 40. Based on this, it is convenient for the electrical component 31 to quickly and reliably exchange heat with the heat exchange member 40 through the insulating heat-conducting member 37, and in particular, it is convenient for the insulating heat-conducting member 37 to quickly conduct the heat generated by the electrical component 31 to the heat exchange member 40. In this way, the heat dissipation performance and heat dissipation efficiency of the power distribution apparatus 30 to the electrical component 31 can be effectively guaranteed and improved, the risk of thermal failure of the electrical component 31 can be reduced, and the service life of the electrical component 31 and the power distribution apparatus 30 can be guaranteed and extended.

The insulating heat-conducting member 37 further includes an insulating material, has an insulation performance, and can play an insulating role. Based on the insulation performance of the insulating heat-conducting member 37, it can be guaranteed that the electrical component 31 and the heat exchange member 40 can be insulated through the insulating heat-conducting member 37, thereby basically avoiding short circuits between the electrical component 31, the insulating heat-conducting member 37, and the heat exchange member 40, thereby effectively reducing the risk of high-voltage short circuit ignition between the electrical component 31, the insulating heat-conducting member 37, and the heat exchange member 40.

The insulating heat-conducting member 37 may be a single-layer structure or a multi-layer structure.

The insulating heat-conducting member 37 may be designed in a variety of shapes, such as a cuboid, a cylinder, or the like.

On the basis of guaranteeing the heat-conducting performance and insulation performance between the insulating heat-conducting member 37 and the electrical component 31, the connection method between the insulating heat-conducting member 37 and the electrical component 31 can be flexibly designed, for example, abutment, bonding, bolt locking connection, and the like can be adopted.

On the basis of guaranteeing the heat-conducting performance and insulation performance between the insulating heat-conducting member 37 and the heat exchange member 40, the connection method between the insulating heat-conducting member 37 and the heat exchange member 40 can be flexibly designed, for example, abutment, bonding, bolt locking connection, and the like can be adopted.

By adopting the above solution, the power distribution apparatus 30 can be insulated and heat-conductively connected to the electrical component 31 through the insulating heat-conducting member 37, and can be insulated and heat-conductively connected to the external heat exchange member 40 through the insulating heat-conducting member 37. Based on this, on the one hand, the insulation performance of the insulating heat-conducting member 37 can be used to guarantee that the electrical component 31 and the heat exchange member 40 can be insulated through the insulating heat-conducting member 37, thereby basically avoiding short circuits between the electrical component 31, the insulating heat-conducting member 37, and the heat exchange member 40, and effectively reducing the risk of high-voltage short circuit ignition between the electrical component 31, the insulating heat-conducting member 37, and the heat exchange member 40. On the other hand, it is convenient to exchange heat and conduct heat between the electrical component 31 and the heat exchange member 40 through the insulating heat-conducting member 37, especially to conduct heat generated by the electrical component 31 to the heat exchange member 40 through the insulating heat-conducting member 37, so as to diffuse and dissipate the heat generated by the electrical component 31 to the outside of the power distribution apparatus 30. As a result, the heat dissipation performance and heat dissipation efficiency of the power distribution apparatus 30 for the electrical component 31 can be effectively guaranteed and improved, the risk of thermal failure of the electrical component 31 can be effectively reduced, and the service life of the electrical component 31 and the power distribution apparatus 30 can be effectively guaranteed and extended.

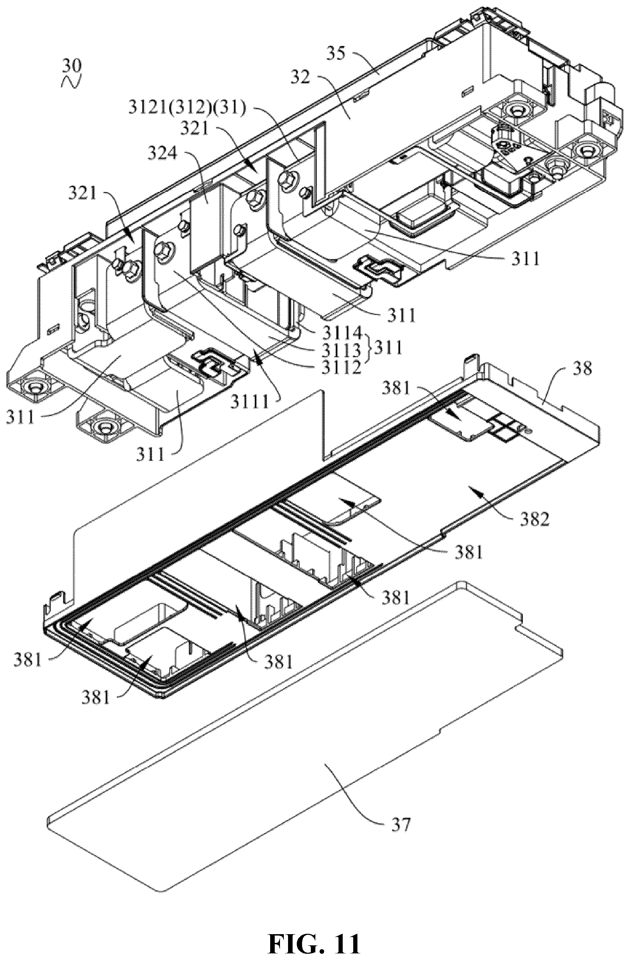

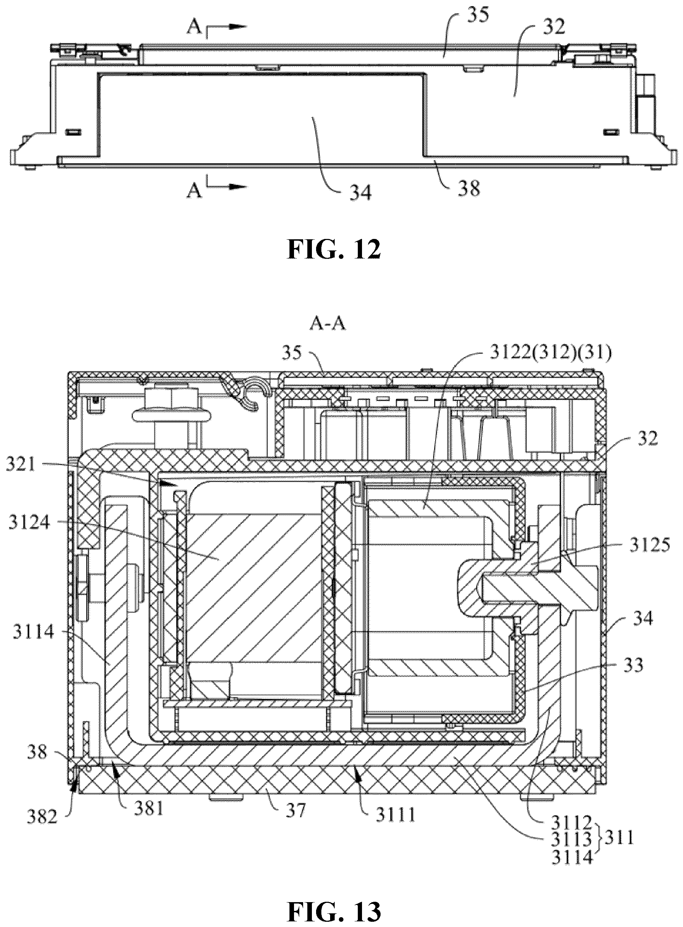

Referring to FIG. 11, FIG. 12, and FIG. 13, in some embodiments of the present application, the electrical component 31 includes a conductive structure 311 in a plate shape. The conductive structure 311 has a heat-conducting surface 3111, and the heat-conducting surface 3111 is connected to the insulating heat-conducting member 37.

It should be noted that the conductive structure 311 is a component of the electrical component 31 and configured to achieve electrical connection. The conductive structure 311 may be in a plate shape, and the conductive structure 311 may include a bar plate, a bus bar, a conductive plate, and the like. The bar plate may include a copper bar, an aluminum bar, and the like.

The conductive structure 311 has a heat-conducting surface 3111, and the heat-conducting surface 3111 may be attached and heat-conductively connected to the insulating heat-conducting member 37. Such arrangement allows the conductive structure 311 of the electrical component 31, which generates more heat during operation, to be directly attached and heat-conductively connected to the insulating heat-conducting member 37 through the heat-conducting surface 3111. Based on this, a heat-conducting contact area between the conductive structure 311 and the insulating heat-conducting member 37 can be guaranteed and increased, so that a large amount of heat generated by the conductive structure 311 can be reliably and effectively conducted to the heat exchange member 40 (as shown in FIG. 3) through the insulating heat-conducting member 37, thereby effectively guaranteeing and improving the heat dissipation performance and heat dissipation efficiency of the power distribution apparatus 30 for the electrical component 31, effectively reducing the risk of thermal failure of the electrical component 31, and effectively guaranteeing and extending the service life of the electrical component 31 and the power distribution apparatus 30.

Furthermore, based on the insulating characteristics of the insulating heat-conducting member 37, the conductive structure 311 can be arranged to be insulated from the insulating heat-conducting member 37. Such arrangement can basically avoid short-circuit between the conductive structure 311 and the insulating heat-conducting member 37, thereby reducing the risk of high-voltage short circuit ignition between the conductive structure 311 and the insulating heat-conducting member 37.

By adopting the above solution, by connecting the heat-conducting surface 3111 of the conductive structure 311 of the electrical component 31 to the insulating heat-conducting member 37, on the one hand, based on the insulating characteristics of the insulating heat-conducting member 37, the conductive structure 311 and the insulating heat-conducting member 37 can be arranged to be insulated from each other, thereby basically avoiding short circuit between the conductive structure 311 and the insulating heat-conducting member 37, and reducing the risk of high-voltage short circuit ignition between the conductive structure 311 and the insulating heat-conducting member 37. On the other hand, the conductive structure 311 of the electrical component 31, which generates more heat during operation, is allowed to be directly attached and heat-conductively connected to the insulating heat-conducting member 37 through the heat-conducting surface 3111. Based on this, a heat-conducting contact area between the conductive structure 311 and the insulating heat-conducting member 37 can be guaranteed and increased, so that a large amount of heat generated by the conductive structure 311 can be reliably and effectively conducted to the heat exchange member 40 through the insulating heat-conducting member 37, thereby effectively guaranteeing and improving the heat dissipation performance and heat dissipation efficiency of the power distribution apparatus 30 for the electrical component 31, effectively reducing the risk of thermal failure of the electrical component 31, and effectively guaranteeing and extending the service life of the electrical component 31 and the power distribution apparatus 30.

Of course, in other embodiments, the electrical component 31 is capable of being insulated and heat-conductively connected to the insulating heat-conducting member 37 through the non-plate conductive structure 311. alternatively, the electrical component 31 is capable of being insulated and heat-conductively connected to the insulating heat-conducting member 37 through a portion other than the conductive structure 311.

Referring to FIG. 11, FIG. 12, and FIG. 13, in some embodiments of the present application, the conductive structure 311 includes a first conductive portion 3112, a second conductive portion 3113, and a third conductive portion 3114. The second conductive portion 3113 is laid on one side of the base 32 facing the insulating heat-conducting member 37. A heat-conducting surface 3111 is provided on one side of the second conductive portion 3113 facing the insulating heat-conducting member 37. The first conductive portion 3112 and the third conductive portion 3114 are respectively connected to different sides of the second conductive portion 3113, and are both arranged to bend toward a side close to the base 32. The first conductive portion 3112 is connected to the corresponding electrical component 31. The third conductive portion 3114 is configured to be connected to an electric component.

It should be noted that the electric component refers to a component that establishes an electrical connection with the electrical component 31. The electric component may be another electrical component 31, or may be a circuit (not limited to a circuit board), an external bus, and the like. The electric components electrically connected to different electrical components 31 may be the same or different.

The conductive structure 311 is a component configured to electrically connect the corresponding electrical component 31 to a corresponding electric component. The corresponding electrical component 31 refers to the electrical component 31 that includes the conductive structure 311 and is electrically connected to the conductive structure 311. The corresponding electric component refers to another component electrically connected to the conductive structure 311 in addition to the corresponding electrical component 31. In other words, the corresponding electrical component 31 and the corresponding electric component are two components connected by the conductive structure 311.

It should be further noted that the conductive structure 311 is of a plate-shaped structure. The conductive structure 311 includes the first conductive portion 3112, the second conductive portion 3113, and the third conductive portion 3114 which are connected in sequence. The first conductive portion 3112 is connected to the corresponding electrical component 31 and is arranged to extend toward one side close to the insulating heat-conducting member 37. The third conductive portion 3114 is connected to the corresponding electric component and is arranged to extend toward one side close to the insulating heat-conducting member 37. The second conductive portion 3113 is bent and connected to one end of the first conductive portion 3112 close to the insulating heat-conducting member 37, and one end of the third conductive portion 3114 is close to the insulating heat-conducting member 37. That is, the second conductive portion 3113 is connected from one end of the first conductive portion 3112 close to the insulating heat-conducting member 37 to one end of the third conductive portion 3114 close to the insulating heat-conducting member 37, and the second conductive portion 3113 is arranged at an angle to the first conductive portion 3112, and the second conductive portion 3113 is arranged at an angle to the third conductive portion 3114.

According to the layout of the corresponding electrical component 31 and the corresponding electric component and the shape of the second conductive portion 3113, the first conductive portion 3112 and the third conductive portion 3114 may be connected to different sides of the second conductive portion 3113, respectively. That is, the first conductive portion 3112 and the third conductive portion 3114 may be connected to adjacent sides of the second conductive portion 3113, or may be connected to opposite sides of the second conductive portion 3113, and so on. That is, the overall shape of the conductive structure 311 can be flexibly designed as needed.

By sequentially bending and connecting the first conductive portion 3112, the second conductive portion 3113, and the third conductive portion 3114, the conductive structure 311 can conveniently and reliably realize electrical connection of the corresponding electrical component 31 to the corresponding electric component.

It should be further noted that the second conductive portion 3113 is laid on one side of the base 32 facing the insulating heat-conducting member 37. That is, the second conductive portion 3113 is arranged on the side of the base 32 facing the insulating heat-conducting member 37 in a posture of being "substantially parallel to a side surface of the base 32 facing the insulating heat-conducting member 37". In this case, on the side of the second conductive portion 3113 facing the insulating heat-conducting member 37, the second conductive portion 3113 can be provided with the above-mentioned heat-conducting surface 3111 for being attached and heat-conductively connected to the insulating heat-conducting member 37. Based on this, the conductive structure 311 can be directly insulated and heat-conductively connected to the insulating heat-conducting member 37 through the heat-conducting surface 3111 of the second conductive portion 3113, thereby reducing the blocking effect of the base 32 on the heat-conducting path between the conductive structure 311 and the insulating heat-conducting member 37, and guaranteeing and increasing the heat-conducting contact area between the conductive structure 311 and the insulating heat-conducting member 37.

By means of the above solution, electrical connection of the corresponding electrical component 31 to the corresponding electric component can be conveniently and reliably realized by the conductive structure 311, and in particular, by the first conductive portion 3112, the second conductive portion 3113, and the third conductive portion 3114 that are bent and connected sequentially. On this basis, the second conductive portion 3113 can be laid on the side of the base 32 facing the insulating heat-conducting member 37, and the heat-conducting surface 3111 is provided on the side of the second conductive portion 3113 facing the insulating heat-conducting member 37, so that the conductive structure 311 can be directly insulated and heat-conductively connected to the insulating heat-conducting member 37 through the heat-conducting surface 3111 of the second conductive portion 3113. Based on this, the blocking effect of the base 32 on the heat-conducting path between the conductive structure 311 and the insulating heat-conducting member 37 can be reduced, and the heat-conducting contact area between the conductive structure 311 and the insulating heat-conducting member 37 can be guaranteed and increased, thereby guaranteeing and improving the heat-conducting effect between the conductive structure 311 and the insulating heat-conducting member 37, facilitating the reliable and effective rapid dissipation of a large amount of heat generated by the conductive structure 311 through the insulating heat-conducting member 37, and guaranteeing and improving the heat dissipation performance and heat dissipation efficiency of the power distribution apparatus 30 to the electrical component 31.

Referring to FIG. 11, FIG. 12, and FIG. 13, in some embodiments of the present application, the conductive structure 311 of the relay 312 is arranged outside the accommodating cavity 321, and the second conductive portion 3113 of the relay 312 is arranged on an outer side of the accommodating cavity 321 close to the insulating heat-conducting member 37.

It should be noted that the conductive structure 311 of the relay 312, that is, the conductive structure 311 configured to electrically connect the relay 312 to another electric component, is arranged outside the accommodating cavity 321 without additionally occupying the inner space of the accommodating cavity 321. In particular, the second conductive portion 3113 of the conductive structure 311 of the relay 312 is arranged on the outer side of the accommodating cavity 321 close to the insulating heat-conducting member 37.

By adopting the above solution, the conductive structure 311 of the relay 312 can be arranged outside the accommodating cavity 321 so that the conductive structure 311 is capable of electrically connecting the relay 312 to another electric component without additionally occupying the inner space of the accommodating cavity 321. Based on this, the design margin and space waste between the base 32 and the relay 312 can be reduced, the assembling and fitting of the base 32, the relay 312, the conductive structure 311 of the relay 312, and the electric component connected to the conductive structure 311 of the relay 312 can be facilitated, and the conductive structure 311 can conveniently and reliably electrically connect the relay 312 to the other electric component. On this basis, the second conductive portion 3113 of the relay 312 can be arranged on an outer side of the accommodating cavity 321 close to the insulating heat-conducting member 37, so that the second conductive portion 3113 of the relay 312 can be exposed on the outer side of the accommodating cavity 321 close to the insulating heat-conducting member 37, so that the conductive structure 311 of the relay 312 can be directly insulated and heat-conductively connected to the insulating heat-conducting member 37 through the second conductive portion 3113. As a result, the blocking effect of the wall of the accommodating cavity 321 on the heat-conducting path between the conductive structure 311 of the relay 312 and the insulating heat-conducting member 37 can be reduced, and the heat-conducting contact area between the conductive structure 311 of the relay 312 and the insulating heat-conducting member 37 can be increased, so as to improve the heat-conducting effect between the relay 312 and the insulating heat-conducting member 37, and reliably and effectively dissipate the heat generated by the relay 312 and its conductive structure 311 quickly through the insulating heat-conducting member 37, which can improve the heat dissipation performance and heat dissipation efficiency of the power distribution apparatus 30 to the relay 312, and reduce the risk of thermal failure of the relay 312.

Referring to FIG. 9, FIG. 11, and FIG. 13, in some embodiments of the present application, the power distribution apparatus 30 includes an encapsulating seat 38. The encapsulating seat 38 is connected to one side of the base 32 close to the insulating heat-conducting member 37. The insulating heat-conducting member 37 is mounted on the encapsulating seat 38. The surface of the insulating heat-conducting member 37 away from the electrical component 31 is exposed on the encapsulating seat 38.

It should be noted that when the power distribution apparatus 30 is arranged on the heat exchange member 40 (as shown in FIG. 3), the power distribution apparatus 30 is mainly arranged on the heat exchange member 40 through the encapsulating seat 38. The encapsulating seat 38 is a component configured at least to mount and fix the insulating heat-conducting member 37.

The electrical component 31 is located on one side of the encapsulating seat 38 away from the heat exchange member 40. In some embodiments, the electrical component 31 may be mounted on the base 32 and fixed through the connection between the base 32 and the encapsulating seat 38, and has substantially stable mounting position and mounting state relative to the encapsulating seat 38.

The insulating heat-conducting member 37 is mounted on the encapsulating seat 38. The mounting method between the insulating heat-conducting member 37 and the encapsulating seat 38 can be flexibly designed. The side of the insulating heat-conducting member 37 facing the electrical component 31 is insulated and heat-conductively connected to the electric component 31. The surface of the insulating heat-conducting member 37 away from the electrical component 31 is exposed on a side surface of the encapsulating seat 38 facing the heat exchange member 40 and is heat-conductively connected to the heat exchange member 40.

By adopting the above solution, the insulating heat-conducting member 37 can be mounted and fixed through the encapsulating seat 38, so that the mounting position and mounting state of the insulating heat-conducting member 37 relative to the encapsulating seat 38 are stable and firm, thereby facilitating the precise and stable alignment of the insulating heat-conducting member 37 and the electrical component 31, and facilitating the accurate and reliable establishment of an insulating heat-connecting connection relationship between the insulating heat-conducting member 37 and the electrical component 31. On this basis, the side of the insulating heat-conducting member 37 facing the electrical component 31 is insulated and heat-conductively connected to the electrical component 31, and the surface of the insulating heat-conducting member 37 away from the electrical component 31 is exposed from the encapsulating seat 38 and heat-conductively connected to the heat exchange member 40; therefore, the insulating heat-conducting member 37 can be directly insulated and heat-conductively connected between the electrical component 31 and the heat exchange member 40, thereby reducing the blocking effect of the encapsulating seat 38 on a heat-conducting path of the insulating heat-conducting member 37, and guaranteeing and improving the heat-conducting effect of the insulating heat-conducting member 37 between the electrical component 31 and the heat exchange member 40.

Of course, in other embodiments, the power distribution apparatus 30 may not include the encapsulating seat 38, but the insulating heat-conducting member 37 may be mounted and fixed on another component of the power distribution apparatus 30.

Referring to FIG. 9, FIG. 11, and FIG. 13, in some embodiments of the present application, the insulating heat-conducting member 37 is embedded in the encapsulating seat 38.

It should be noted that part or all of the insulating heat-conducting member 37 is embedded in the encapsulating seat 38. The side of the insulating heat-conducting member 37 facing the electrical component 31 is insulated and heat-conductively connected to the electric component 31. The surface of the insulating heat-conducting member 37 away from the electrical component 31 is exposed on a side surface of the encapsulating seat 38 facing the heat exchange member 40 and is heat-conductively connected to the heat exchange member 40.

By adopting the above solution, on the basis of the previous embodiment, at least part of the insulating heat-conducting member 37 can be embedded in the encapsulating seat 38. Based on this, on the one hand, at least part of the insulating heat-conducting member 37 is capable of sharing a space with the encapsulating seat 38, thereby saving the space occupied by both the insulating heat-conducting member 37 and the encapsulating seat 38. On the other hand, the insulating heat-conducting member 37 can be directly insulated and heat-conductively connected between the electrical component 31 and the heat exchange member 40 through the encapsulating seat 38, thereby reducing the blocking effect of the encapsulating seat 38 on the heat-conducting path of the insulating heat-conducting member 37, which can help guarantee and improve the heat-conducting effect of the insulating heat-conducting member 37 between the electrical component 31 and the heat exchange member 40.

Referring to FIG. 9, FIG. 11, and FIG. 13, in some embodiments of the present application, a first position-limiting structure 381 is arranged on the side of the encapsulating seat 38 facing the electrical component 31, and is configured to position-limit the portion of the electrical component 31 connected to the insulating heat-conducting member 37.

It should be noted that the first position-limiting structure 381 is arranged on the side surface of the encapsulating seat 38 facing the electrical component 31. The structure of the first position-limiting structure 381 may be designed in a variety of ways. For example, the first position-limiting structure 381 may be of a hole-shaped structure, a groove-shaped structure, a frame structure, or the like.

The electrical component 31 is configured for the part, that is heat-conductively connected to the insulating heat-conducting member 37 (such as the second conductive portion 3113 mentioned above), to be mounted in the first position-limiting structure 381 in a position-limiting manner and be insulated and heat-conductively connected to the surface of the insulating heat-conducting member 37 corresponding to the first position-limiting structure 381. When the part of the electrical component 31 configured to be heat-conductively connected to the insulating heat-conducting member 37 can be position-limited in the first position-limiting structure 381, the shape of the part of the electrical component 31 and the shape of the first position-limiting structure 381 can be set the same or differently, and the fit between the part of the electrical component 31 and the first position-limiting structure 381 may be a clearance fit, a transition fit, or an interference fit.

By adopting the above solution, the first position-limiting structure 381 can be arranged on the encapsulating seat 38, so that the part of the electrical component 31 configured to be heat-conductively connected to the insulating heat-conducting member 37 is position-limitedly mounted in the first position-limiting structure 381, and is insulated and heat-conductively connected to the surface of the insulating heat-conducting member 37 corresponding to the first position-limiting structure 381. Based on this, the part of the electrical component 31 configured to be heat-conductively connected to the insulating heat-conducting member 37 can be position-limited and positioned by the first position-limiting structure 381 of the encapsulating seat 38, which facilitates rapid and accurate alignment and fitting between each electrical component 31 and the encapsulating seat 38, and each electrical component 31 is capable of being accurately aligned with the insulating heat-conducting member 37 mounted in the encapsulating seat 38, which can facilitate stabilizing the relative position and relative state between the electrical component 31 and the insulating heat-conducting member 37, so that the electrical component 31 and the insulating heat-conducting member 37 can be accurately and reliably isolated and heat-conductively connected, and the heat-conducting effect between the electrical component 31 and the insulating heat-conducting member 37 can be guaranteed.

Of course, in other embodiments, the encapsulating seat 38 may not be provided with the first position-limiting structure 381, and the surface of the insulating heat-conducting member 37 facing the electrical component 31 may be exposed at a corresponding side surface of the encapsulating seat 38 and heat-conductively connected to at least part of the electrical component 31.

Referring to FIG. 9, FIG. 11, and FIG. 13, in some embodiments of the present application, a second position-limiting structure 382 is arranged on the side of the encapsulating seat 38 away from the electrical component 31, and is configured to position-limit the insulating heat-conducting member 37.

It should be noted that the second position-limiting structure 382 is arranged on the side surface of the encapsulating seat 38 away from the electrical component 31 (that is, the side surface of the encapsulating seat 38 facing the heat exchange member 40). The structure of the second position-limiting structure 382 may be designed in a variety of ways. For example, the second position-limiting structure 382 may be of a groove-shaped structure, a hole-shaped structure, a frame structure, or the like.

The insulating heat-conducting member 37 is position-limitedly mounted on the second position-limiting structure 382. When the insulating heat-conducting member 37 is position-limitedly mounted in the second position-limiting structure 382, the shape of the second position-limiting structure 382 and the shape of the insulating heat-conducting member 37 may be set the same or differently, and the fit between the insulating heat-conducting member 37 and the second position-limiting structure 382 may be a clearance fit, a transition fit, or an interference fit.

By adopting the above solution, the second position-limiting structure 382 can be arranged on the side of the encapsulating seat 38 away from the electrical component 31, so as to facilitate the insulating heat-conducting member 37 to be position-limitedly mounted in the second position-limiting structure 382. Based on this, the insulating heat-conducting member 37 can be position-limited and accommodated by the second position-limiting structure 382 of the encapsulating seat 38, so that the insulating heat-conducting member 37 and the encapsulating seat 38 can be assembled quickly and accurately, and the insulating heat-conducting member 37 is capable of being accurately aligned with the electrical component 31 to be heat-conductively connected; therefore, the insulating heat-conducting member 37 can accurately, stably, and reliably perform the heat conduction function.

Referring to FIG. 4 to FIG. 13, in combination with the above-mentioned embodiments, an embodiment of the present application provides a specific example of a power distribution apparatus 30.

The power distribution apparatus 30 includes a base 32 and a relay 312. Two accommodating cavities 321 are provided on one side of the base 32. At least two relays 312 are provided, and the at least two relays 312 include a main positive relay 3121 and a main negative relay 3122. The main positive relay 3121 is fixedly mounted in one of the accommodating cavities 321. The main positive relay 3121 is a shellless relay. An outer wall of a switch unit 3124 of the main positive relay 3121 is exposed in the accommodating cavity 321. A wall of the accommodating cavity 321 is connected to the main positive relay 3121, so that the main positive relay 3121 is fixed to the accommodating cavity 321. The main negative relay 3122 is fixedly mounted in the other of the accommodating cavities 321. The main negative relay 3122 is a shellless relay. Outer walls of a switch unit 3124 of the main negative relay 3122 are all exposed in the accommodating cavity 321. A wall of the accommodating cavity 321 is connected to the main negative relay 3122, so that the main negative relay 3122 is fixed to the accommodating cavity 321. Based on this, on the basis of accommodating, limiting, fixing, and protecting the main positive relay 3121 and the main negative relay 3122 through the base 32, shell structures of the main positive relay 3121 and the main negative relay 3122 can be omitted, thereby making the layout of the power distribution apparatus 30 compact, reducing the design margin, space waste, and occupied space of the power distribution apparatus 30, reducing the weight of the power distribution apparatus 30, and facilitating the formation of an integrated, miniaturized, lightweight, and simplified power distribution apparatus 30, and reducing the production cost of the power distribution apparatus 30.

An inner wall 3211 of the accommodating cavity 321 includes a bottom wall 3212, a top wall 3213, a first side wall 3214, a second side wall 3215, and a third side wall 3216. The bottom wall 3212 is used to support the relay 312, and the top wall 3213 is arranged opposite to the bottom wall 3212. The first side wall 3214 is arranged opposite to the second side wall 3215. The third side wall 3216 is arranged opposite to the opening 3217 of the accommodating cavity 321. The bottom wall 3212, the top wall 3213, the first side wall 3214, the second side wall 3215 and the third side wall 3216 are all provided with protrusion structures 323. The protrusion structures 323 arranged on the bottom wall 3212, the top wall 3213, the first side wall 3214, and the second side wall 3215 are first protrusions 3231. The first protrusion 3231 extends in a direction away from the opening 3217. The protrusion structures 323 arranged on the third side wall 3216 are second protrusions 3232, and the second protrusions 3232 are cross-connected. Based on this, during the assembling of the relay 312 being picked and placed in the accommodating cavity 321, the bottom wall 3212, the top wall 3213, the first side wall 3214, and the second side wall 3215 can all follow a disassembling and assembling direction of the relay 312 and the accommodating cavity 321 through the first protrusions 3231, so as to reduce the friction between the wall and the relay 312, especially reduce the friction in directions other than the disassembling and assembling direction. Moreover, the bottom wall 3212, the top wall 3213, the first side wall 3214, the second side wall 3215, and the third side wall 3216 can each form a first gap 322 with the relay 312 through a region where the protrusion structure 323 is not provided, so as to form the assembling margin through the first gap 322 to provide the assembling space. Therefore, it may be conducive to improving the assembling convenience and assembling efficiency between the relay 312 and the accommodating cavity 321. When the relay 312 has been placed in the accommodating cavity 321, the bottom wall 3212, the top wall 3213, the first side wall 3214, the second side wall 3215, and the third side wall 3216 can all abut against the relay 312 through the protrusion structures 323, so as to guarantee and enhance the position-limiting and positioning effects for the relay 312. Moreover, the connection space can be formed through the first gap 322 to fill a structural adhesive, so as to facilitate the relay 312 to be stably and reliably fixed in the accommodating cavity 321 by the structural adhesive. Therefore, it may be conducive to improving the mounting stability of the relay 312 in the accommodating cavity 321.

The power distribution apparatus 30 includes two covering members 33. The covering member 33 may be snap-connected to the inner wall 3211 of the accommodating cavity 321 through snaps 333. Therefore, the two covering members 33 can block openings 3217 of the two accommodating cavities 321 in a one-to-one manner. Based on this, the covering members 33 can cooperate with the base 32 to form all-round protection for the relay 312 in the accommodating cavity 321, thereby improving the protection effect of the power distribution apparatus 30 on the relay 312, and extending the service life of the relay 312 and the power distribution apparatus 30. The covering member 33 can reliably prevent the relay 312 from being detached from the opening 3217 of the accommodating cavity 321, and in particular prevent the relay 312 from being detached from the accommodating cavity 321 due to vibration generated during operation, thereby guaranteeing the mounting stability and mounting reliability of the relay 312 by the power distribution apparatus 30. The covering member 33 can reliably prevent external devices from contacting, colliding with, and damaging the relay 312, thereby extending the service life of the relay 312 and the power distribution apparatus 30, and reducing the safety hazards of the power distribution apparatus 30.

The relay 312 is provided with two contacts 3125, and the contacts 3125 of the relay 312 are arranged facing the opening 3217. Correspondingly, the covering member 33 is provided with two through holes 331, and the two through holes 331 expose the two contacts 3125 of the relay 312 in an one-to-one manner. Based on this, the covering member 33 can expose the contacts 3125 of the relay 312 through the through holes 331, so that the contacts 3125 of the relay 312 can be connected to the high-voltage circuit and play the role of controlling on/off of the high-voltage circuit. Moreover, since the contacts 3125 of the relay 312 are separated in different through holes 331, it is conducive to improving the insulation performance between the two contacts 3125 of the relay 312, thereby reducing the risk of short circuit and reducing the safety hazards of the power distribution apparatus 30.

A barrier structure 332 is arranged on one side of the covering member 33 away from the accommodating cavity 321. The barrier structure 332 is located between the two through holes 331. Based on this, when the two contacts 3125 of the relay 312 pass through the two through holes 331 of the covering member 33 in a one-to-one manner, the covering member 33 can insulate and separate, through the barrier structure 332, the two contacts 3125 correspondingly exposed in the two through holes 331. Therefore, the creepage distance between the two contacts 3125 of the relay 312 can be increased through the barrier structure 332, and the insulation performance between the two contacts 3125 of the relay 312 can be improved, thereby reducing the risk of short circuit and reducing the safety hazard of the power distribution apparatus 30.

The two accommodating cavities 321 are arranged adjacent to each other, that is, close to each other. The base 32 is provided with an insulating structure 324, and the insulating structure 324 is arranged between the two accommodating cavities 321. The insulating structure 324 can insulate and separate the two accommodating cavities 321, and in particular can insulate and separate the main positive relay 3121 from the main negative relay 3122, and in particular can insulate and separate the contact 3125 of the main positive relay 3121 from the contact 3125 of the main negative relay 3122. Based on this, the insulation performance between the contact 3125 of the main positive relay 3121 and the contact 3125 of the main negative relay 3122 can be improved, the risk of short circuit can be reduced, and the reliability and safety of the power distribution apparatus 30 can be improved.

The power distribution apparatus 30 includes a shielding member 34. The shielding member 34 is arranged on one side of the two covering members 33 away from the accommodating cavity 321. The shielding member 34 can shield the two covering members 33, as well as the contact 3125 of the main positive relay 3121 and the contact 3125 of the main negative relay 3122. Based on this, the shielding member 34 can be used to protect the two covering members 33, the contact 3125 of the main positive relay 3121 and the contact 3125 of the main negative relay 3122, so as to guarantee and extend the service life of the relay 312 and the power distribution apparatus 30. The shielding member 34 can also reliably prevent human hands or external devices from contacting the contact 3125 of the main positive relay 3121 and the contact 3125 of the main negative relay 3122 to conduct electricity, thereby reducing the safety hazards of the power distribution apparatus 30.

The power distribution apparatus 30 includes at least two electrical components 31. Each electrical component 31 includes a main positive relay 3121, a main negative relay 3122, a pre-charging relay 3123, a shunt 3131, a Hall current sensor 3132, a main fuse 3141, and a pre-charging resistor 315. The electrical components 31 are all mounted on the base 32. The pre-charging relay 3123 is arranged on one side of the main positive relay 3121 away from the main negative relay 3122 and is arranged close to the main positive relay 3121. The pre-charging resistor 315 is arranged on one side of the pre-charging relay 3123 away from the main positive relay 3121 and close to the pre-charging relay 3123. The main fuse 3141 is arranged on the side of the main positive relay 3121 away from the main negative relay 3122, and is arranged beside the pre-charging relay 3123 and the pre-charging resistor 315. The main fuse 3141 is arranged close to the main positive relay 3121, the pre-charging relay 3123, and the pre-charging resistor 315. The shunt 3131 and the Hall current sensor 3132 are both current sensors 313. The Hall current sensor 3132 is arranged on one side of the main fuse 3141 away from the main positive relay 3121. The shunt 3131 is arranged on one side of the main negative relay 3122 away from the main positive relay 3121. The main positive relay 3121, the main negative relay 3122, the pre-charging relay 3123, the shunt 3131, the Hall current sensor 3132, the main fuse 3141, and the pre-charging resistor 315 construct corresponding electrical connection relationships according to a schematic circuit diagram of the power distribution apparatus 30. The schematic circuit diagram of the power distribution apparatus 30 is the technology well known to those skilled in the art and will not be described in detail here. Based on this, the main positive relay 3121, the main negative relay 3122, the pre-charging relay 3123, the shunt 3131, the Hall current sensor 3132, the main fuse 3141, and the pre-charging resistor 315 are capable of achieving a compactness and optimized layout, thereby reducing the design margin, space waste, and occupied space of the power distribution apparatus 30, and can reduce the size of the power distribution apparatus 30 in a height direction of the base 32 (corresponding to an assembling direction of the cover body 35, the base 32, and the encapsulating seat 38), and can reduce the overall external dimension of the power distribution apparatus 30, thereby being conducive to forming an integrated and miniaturized power distribution apparatus 30.

The power distribution apparatus 30 further includes a cover body 35, and the cover body 35 is mounted on one side of the base 32. Based on the compact layout of the above-mentioned electrical components 31, the base 32 and the cover body 35 can enclose an internal space to accommodate the mounting of the pre-charging relay 3123 and the pre-charging resistor 315. The circuit element 36 is provided on one side of the cover body 35 facing each electrical component 31. The circuit element 36 can be configured to be electrically connected to each electrical component 31 to establish the electrical connection relationship required by each electrical component 31, thereby guaranteeing that the power distribution apparatus 30 is capable of achieving the required functions.

The electrical components 31 are each provided with a first connecting element 317, and the first connecting element 317 has a first connecting portion 3171 configured to be electrically connected to the circuit element 36 in a detachable manner. For any electrical component 31, a gap between it and an electrical component 31 adjacent thereto can serve as a second gap 316, and the first connecting portion 3171 of the first connecting element 317 arranged therein is located outside the second gaps 316. Taking the pre-charging relay 3123 as an example, the main positive relay 3121, the pre-charging resistor 315, and the main fuse 3141 are all arranged adjacent to the pre-charging relay 3123. A gap between the main positive relay 3121 and the pre-charging relay 3123, a gap between the pre-charging resistor 315 and the pre-charging relay 3123, and a gap between the main fuse 3141 and the pre-charging relay 3123 can all be used as the second gaps 316, but the sizes of these second gaps 316 can be set to the same or different. The first connecting portion 3171 of the first connecting element 317 provided for the pre-charging relay 3123 can be arranged outside the second gaps 316 of the pre-charging relay 3123, that is, the first connecting portion 3171 provided for the pre-charging relay 3123 can be arranged outside the gap between the main positive relay 3121 and the pre-charging relay 3123, outside the gap between the pre-charging resistor 315 and the pre-charging relay 3123, and outside the gap between the main fuse 3141 and the pre-charging relay 3123. Therefore, in this embodiment, the first connecting portion 3171 of the pre-charging relay 3123 is arranged on the side of the pre-charging relay 3123 facing the cover body 35. By analogy, the respective first connecting portions 3171 of the main positive relay 3121, the main negative relay 3122, the shunt 3131, the Hall current sensor 3132, the main fuse 3141, and the pre-charging resistor 315 can be arranged to avoid the respective second gaps 316 as much as possible. Of course, according to layout design requirements, some electrical components 31 may have their first connecting portions 3171 arranged in their second gaps 316. Based on this, the first connecting portion 3171 can be arranged outside the second gaps 316 of the corresponding electrical component 31, so that a connection operation of the first connecting portion 3171 can be performed in the space outside the second gaps 316 of the corresponding electrical component 31, thereby guaranteeing and improving the operational convenience of connecting and disconnecting the first connecting portion 3171. Moreover, the second gaps 316 of the electrical components 31 neither need to provide an accommodation space for the first connecting portion 3171, nor need to provide a connection operation space for the first connecting portion 3171, thereby facilitating compressing the gap between the electrical component 31 and the adjacent electrical component 31 as needed, which facilitates compactness of the overall layout of the electrical components 31, thereby facilitating the formation of an integrated, compact, and miniaturized power distribution apparatus 30, and being conducive to improving the spatial utilization and energy density of the power distribution apparatus 30.

The circuit element 36 includes two connectors 361, one of the connector 361 is configured to be connected to the battery unit 10 (as shown in FIG. 3) to achieve high-voltage sampling, and the other connector 361 is configured to be connected to the battery unit 10 for low-voltage control. The two connectors 361 are both embedded in the cover body 35, and sockets 3611 of the two connectors 361 are both exposed outside the cover body 35. According to the numbers and positions of the electrical components 31 that the connectors 361 need to connect, the connectors 361 can each be provided with at least one second connecting elements 362 as desired. The second connecting element 362 includes a conductive connecting portion 3622, one end of the conductive connecting portion 3622 is electrically connected to the connector 361, and the other end of the conductive connecting portion 3622 is arranged to extend toward the electrical component 31 to be connected. At one end of the conductive connecting portion 3622 close to the corresponding electrical component 31, the second connecting element 362 may be bent to form a second connecting portion 3621. The second connecting portion 3621 is arranged to bend toward the corresponding electrical component 31, and is configured to be plugged and fit in the first connecting portion 3171 of the corresponding electrical component 31 in a detachable manner. The plug fitting direction of the second connecting portion 3621 and the corresponding first connecting portion 3171 can correspond to the assembling direction of the cover body 35 and the base 32. Based on this, when the assembling between the cover body 35 and the base 32 is completed, the second connecting portion 3621 and the corresponding first connecting portion 3171 can be accurately aligned and the plug fitting of the second connecting portion 3621 and the corresponding first connecting portion 3171 can be completed at the same time, thereby reducing the assembling steps, guaranteeing and improving the connection reliability between the connector 361 and the electrical component 31, and improving the assembling efficiency and structural reliability of the power distribution apparatus 30.

The conductive connecting portion 3622 adopts a conductive plate, an FPC, or a PCB to replace a wiring harness, thereby reducing the setting of the wiring harness, reducing the problems of wiring harness interference and wiring harness wear, guaranteeing and improving the structural reliability of the connector 361 and the second connecting element 362, and guaranteeing and improving the reliability and safety of using the power distribution apparatus 30. The connector 361 is embedded in the cover body 35, and the conductive connecting portion 3622 is embedded in the cover body 35. The cover body 35, the connector 361, and the conductive connecting portion 3622 are integrated by one-piece injection molding.

The power distribution apparatus 30 includes an encapsulating seat 38. The encapsulating seat 38 is mounted on one side of the base 32 away from the cover body 35. Based on the compact layout of the electrical components 31, the base 32 and the encapsulating seat 38 can enclose an internal space to accommodate the mounting of the main fuse 3141.

When the power distribution apparatus 30 is arranged on the heat exchange member 40 (as shown in FIG. 3), the power distribution apparatus 30 is mainly arranged on the heat exchange member 40 through the encapsulating seat 38. A second position-limiting structure 382 is provided on one side of the encapsulating seat 38 facing the heat exchange member 40, and the second position-limiting structure 382 is a groove-shaped structure. The power distribution apparatus 30 includes an insulating heat-conducting member 37. One insulating heat-conducting member 37 is arranged and embedded in the second position-limiting structure 382. The insulating heat-conducting member 37 and the encapsulating seat 38 are integrally formed. The insulating heat-conducting member 37 protrudes from a notch of the second position-limiting structure 382 toward a side surface of the heat exchange member 40 and is heat-conductively connected to the heat exchange member 40.

The electrical components 31 mounted on the base 32 are each provided with a conductive structure 311. The conductive structure 311 includes a first conductive portion 3112, a second conductive portion 3113, and a third conductive portion 3114. The first conductive portion 3112 is connected to the corresponding electrical component 31 and is arranged to extend toward one side close to the encapsulating seat 38. The third conductive portion 3114 is connected to the corresponding electric component and is arranged to extend toward one side close to the encapsulating seat 38. The second conductive portion 3113 is bent and connected to one end of the first conductive portion 3112 close to the encapsulating seat 38, and one end of the third conductive portion 3114 is close to the encapsulating seat 38. The second conductive portion 3113 is laid on one side of the base 32 facing the encapsulating seat 38. A first position-limiting structure 381 is provided on one side of the encapsulating seat 38 facing the base 32, the first position-limiting structure 381 is a hole-shaped structure, and the first position-limiting structure 381 is in communication with a groove bottom of the second position-limiting structure 382. The second conductive portions 3113 of the electrical components 31 are respectively limited in the corresponding first position-limiting structures 381. A side surface of the second conductive portion 3113 close to the insulating heat-conducting member 37 is provided with a heat-conducting surface 3111, and the heat-conducting surface 3111 is insulated and heat-conductively connected to a surface of the insulating heat-conducting member 37 corresponding to the first position-limiting structure 381.

Based on this, during the operation of the electrical component 31, the insulating heat-conducting member 37 can conduct the heat generated by the electrical component 31, especially the conductive structure 311, to the heat exchange member 40, so as to quickly dissipate the heat of the electrical component 31 to the outside of the power distribution apparatus 30, thereby improving the heat dissipation performance and heat dissipation efficiency of the power distribution apparatus 30 for the electrical component 31, reducing the risk of thermal failure of the electrical component 31, and guaranteeing and extending the service life of the power distribution apparatus 30. The insulating heat-conducting member 37 adopts a ceramic member with excellent heat-conducting performance and voltage tolerance, so that the insulating heat-conducting member 37 is capable of reliably performing the heat conduction function, and at the same time reduce the risk of the insulating heat-conducting member 37 being broken down by a high voltage during the operation of the electrical component 31, thereby guaranteeing and extending the service life of the insulating heat-conducting member 37, and guaranteeing and improving the service life and safety of the power distribution apparatus 30.

The conductive structure 311 of the relay 312 is arranged outside the accommodating cavity 321 without additionally occupying the inner space of the accommodating cavity 321. In particular, the second conductive portion 3113 of the conductive structure 311 of the relay 312 is arranged on the outer side of the accommodating cavity 321 close to the insulating heat-conducting member 37, so that the conductive structure 311 of the relay 312 can be directly insulated and heat-conductively connected to the insulating heat-conducting member 37 through the second conductive portion 3113.

Referring to FIG. 3 and FIG. 4, a battery 1 is provided in some embodiments of the present application, including the power distribution apparatus 30 according to the embodiments of the present application.

By adopting the above solution, the battery 1 can guarantee and improve the space utilization, volume utilization, and energy density of the battery 1 by applying the power distribution apparatus 30 according to the embodiments of the present application.

Referring to FIG. 1, an electrical device is provided in some embodiments of the present application, including the battery 1 according to the embodiments of the present application.

By adopting the above solution, the electrical device can guarantee and improve the use performance of the electrical device by applying the battery 1 according to the embodiments of the present application.

The above descriptions are merely preferred embodiments of the present application, and are not intended to limit the present application. Any modification, equivalent replacement, and improvement made within the spirit and principle of the present application shall fall within the protection scope of the present application.

## Claims

1. A power distribution apparatus, comprising:
a base, forming an accommodating cavity; and
a relay fixedly mounted on the base, wherein the relay comprises a switch unit, at least part of an outer wall of the switch unit is exposed in the accommodating cavity, and an inner wall of the accommodating cavity is connected to the relay to fix the relay in the accommodating cavity.

2. The power distribution apparatus according to claim 1, wherein the relay abuts against at least part of the inner wall.

3. The power distribution apparatus according to claim 2, wherein there is a first gap between the relay and at least part of the inner wall.

4. The power distribution apparatus according to claim 3, wherein the first gap is configured to be filled with structural adhesive, and the relay is bonded to at least part of the inner wall by the structural adhesive.

5. The power distribution apparatus according to any one of claims 2 to 4, wherein the inner wall is provided with a protrusion structure, and the inner wall abuts against the relay through at least part of the protrusion structure.

6. The power distribution apparatus according to claim 5, wherein the accommodating cavity has an opening, the inner wall comprises a bottom wall, a top wall, a first side wall, a second side wall, and a third side wall, the bottom wall is configured to support the relay, the top wall is arranged opposite to the bottom wall, the first side wall is arranged opposite to the second side wall, and the third side wall is arranged opposite to the opening; and
at least some walls among the bottom wall, the top wall, the first side wall, the second side wall, and the third side wall are provided with the protrusion structures.

7. The power distribution apparatus according to claim 6, wherein the protrusion structures provided on the bottom wall, the top wall, the first side wall, and the second side wall are first protrusions, and the first protrusions are arranged to extend in a direction away from the opening.

8. The power distribution apparatus according to claim 6 or 7, wherein the protrusion structure provided on the third side wall is a second protrusion, there are at least two second protrusions, and the second protrusions are cross-connected.

9. The power distribution apparatus according to any one of claims 1 to 8, wherein the accommodating cavity has an opening, the power distribution apparatus comprises a covering member, and the covering member is connected to the base, for blocking the opening.

10. The power distribution apparatus according to claim 9, wherein the covering member has a through hole penetrated for a contact of the relay to pass through.

11. The power distribution apparatus according to claim 10, wherein each covering member is provided with at least one through hole, each relay has at least two contacts, each of the through holes corresponds to at least one of the contacts, and each of the through holes is used to allow the corresponding contact to pass through.

12. The power distribution apparatus according to claim 11, wherein the covering member is provided with a barrier structure for separating two adjacent contacts of the relay.

13. The power distribution apparatus according to any one of claims 10 to 12, wherein the power distribution apparatus comprises a shielding member, and the shielding member is arranged on one side of the covering member away from the accommodating cavity and is configured to shield the contact of the relay.

14. The power distribution apparatus according to any one of claims 9 to 13, wherein the covering member is connected to the inner wall of the accommodating cavity by a snap.

15. The power distribution apparatus according to any one of claims 1 to 14, wherein there are at least two accommodating cavities, there are at least two relays, and at least some of the relays are mounted in the accommodating cavities in a one-to-one manner.

16. The power distribution apparatus according to claim 15, wherein the base is provided with at least one insulating structure, and the insulating structure is arranged between two adjacent accommodating cavities, for separating contacts of the two corresponding relays.

17. The power distribution apparatus according to any one of claims 1 to 16, wherein the power distribution apparatus comprises an electrical component and a cover body, the electrical component comprises the relay, and at least two electrical components are provided and are both mounted on the base; and
the cover body is arranged on the same side of the electrical components and connected to the base, a circuit element is arranged on one side of the cover body facing the electrical components, for being electrically connected to the electrical components.

18. The power distribution apparatus according to claim 17, wherein a gap between the electrical component and the adjacent electrical component is a second gap, the electrical component is provided with a first connecting element, the first connecting element comprises a first connecting portion for being detachably connected to the circuit element, and the first connecting portion is located outside the second gaps of the corresponding electrical components.

19. The power distribution apparatus according to claim 17 or 18, wherein the circuit element comprises a connector and a second connecting element, the connector is embedded in the cover body, and a socket of the connector is exposed outside the cover body; and
the second connecting element comprises a conductive connecting portion and a second connecting portion, one end of the conductive connecting portion is connected to the connector, the other end of the conductive connecting portion is connected to the second connecting portion, and the second connecting portion is arranged to bend toward the corresponding electrical component, for being detachably connected to the corresponding electrical component.

20. The power distribution apparatus according to claim 19, wherein the conductive connecting portion is embedded in the cover body;
and/or, the cover body, the connector, and the conductive connecting portion form an integrated structure.

21. The power distribution apparatus according to any one of claims 1 to 20, wherein the power distribution apparatus comprises an electrical component and an insulating heat-conducting member, the electrical component comprises the relay, and the electrical component is mounted on the base; and
one side of the insulating heat-conducting member is connected to at least part of the electrical component, and the other side of the insulating heat-conducting member is used to be connected to a heat exchange member, and the insulating heat-conducting member is configured to transfer heat from the electrical component to the heat exchange member.

22. The power distribution apparatus according to claim 21, wherein the power distribution apparatus comprises an encapsulating seat, and the encapsulating seat is connected to one side of the base close to the insulating heat-conducting member; and
the insulating heat-conducting member is mounted on the encapsulating seat, and a surface of the insulating heat-conducting member away from the electrical component is exposed from the encapsulating seat.

23. A battery, comprising the power distribution apparatus according to any one of claims 1 to 22.

24. An electrical device, comprising the battery according to claim 23.
